# EUROPEAN PATENT SPECIFICATION

(11) **EP 4 418 322 B1**
(45) Date of publication and mention of the grant of the patent: **26.11.2025**
(21) Application number: 22880947.1
(22) Date of filing: 07.10.2022
(51) Int. Cl.: H10F 39/12, H10F 39/00, H10F 30/20

(54) **PHOTOELECTRIC CONVERSION ELEMENT AND IMAGING DEVICE**
PHOTOELEKTRISCHES UMWANDLUNGSELEMENT UND ABBILDUNGSVORRICHTUNG
ÉLÉMENT DE CONVERSION PHOTOÉLECTRIQUE ET DISPOSITIF D'IMAGERIE

(30) Priority: 15.10.2021 WO PCT/JP2021/038328
(43) Date of publication of application: 21.08.2024
(73) Proprietor: Sony Semiconductor Solutions Corporation, Atsugi-shi, Kanagawa 243-0014 (JP)
(72) Inventor: TAJIRI, Yusuke, Atsugi-shi, Kanagawa 243-0014 (JP); MINARI, Hideki, Atsugi-shi, Kanagawa 243-0014 (JP); SHIMIZU, Hiroshi, Atsugi-shi, Kanagawa 243-0014 (JP)
(74) Representative: Müller Hoffmann & Partner
(86) International application number: PCT/JP2022/037593
(87) International publication number: WO 2023/063252

(56) References cited:
- EP-A1- 3 869 561
- WO-A1-2005/093857
- WO-A1-2017/159130
- WO-A1-2018/212175
- WO-A1-2019/211968
- WO-A1-2021/070586
- JP-A- 2009 105 309
- JP-A- 2013 234 106
- JP-A- 2018 093 126
- JP-A- H1 183 619

## Description

### [Technical Field]

The present disclosure relates to a photoelectric conversion element and an imaging device.

### [Background Art]

Image sensors having sensitivity in the infrared region (also called infrared sensors) are widely used in surveillance cameras and the like (see PTL 1). Since the image sensor described in PTL 1 does not have a pixel separation structure in a photoelectric conversion layer, there is a risk that so-called crosstalk, in which charges generated near the light incidence surface flow into adjacent pixels, may occur.

Further, PTL 2 discloses a photoelectric conversion element in which pixels having a light absorption layer containing a compound semiconductor material are separated by a groove. In the photoelectric conversion element of PTL 2, since the pixels are separated by a groove, crosstalk can be suppressed. However, since the groove is formed of an insulating layer, dark current is easily generated near the interface with the insulating layer. Further, since photoelectric conversion is not performed in the groove region, the photoelectric conversion region becomes narrow, and there is a possibility that sensitivity may decrease.

Document WO 2017/159130 A1 shows a prior-art photoelectric conversion element.

### [Citation List]

### [Patent Literature]

[PTL 1]
   WO 2018/194030
[PTL 2]
   WO 2018/212175

### [Summary]

### [Technical Problem]

Therefore, the present disclosure provides a photoelectric conversion element and an imaging device that can suppress crosstalk without reducing sensitivity.

### [Solution to Problem]

In order to solve the above problems, according to the present disclosure, there is provided a photoelectric conversion element including: a first semiconductor layer of a first conductivity type containing a compound semiconductor material;
a second semiconductor layer of a first conductivity type containing a compound semiconductor material having a larger band gap than the first semiconductor layer and stacked on a side of the first semiconductor layer opposite to the light incidence surface;
a third semiconductor layer of a first conductivity type containing a compound semiconductor material having a larger band gap than the first semiconductor layer and stacked on the light incidence surface side of the first semiconductor layer;
a first diffusion layer of a second conductivity type disposed to penetrate the second semiconductor layer from a side of the second semiconductor layer opposite to the light incidence surface and extend into the first semiconductor layer;
a first electrode in contact with the first diffusion layer on the side of the second semiconductor layer opposite to the light incidence surface;
a second diffusion layer of a second conductivity type disposed in a depth direction of the third semiconductor layer from a light incidence surface side of the third semiconductor layer;
a second electrode in contact with the second diffusion layer on the light incidence surface side of the third semiconductor layer; and
an insulating layer disposed between the second electrode and the third semiconductor layer.

The first diffusion layer, the second diffusion layer, the first electrode, and the second electrode may be provided for each pixel, and
each of the first semiconductor layer, the second semiconductor layer, and the third semiconductor layer may be arranged across a plurality of pixel regions.

The first diffusion layer and the first electrode may be provided m (m is an integer of 1 or more) for each pixel, or are provided for every m (m is an integer of 1 or more) pixels, and
each of the first semiconductor layer, the second semiconductor layer, and the third semiconductor layer may be arranged across a plurality of pixel regions.

The second diffusion layer and the second electrode may be provided n (n is an integer of 1 or more) for each pixel, or are provided for every n (n is an integer of 1 or more) pixels, and
each of the first semiconductor layer, the second semiconductor layer, and the third semiconductor layer may be arranged across a plurality of pixel regions.

A plurality of the second diffusion layers and a corresponding plurality of the second electrodes are provided for each pixel, and the photoelectric conversion element may further include:
a via electrically connected to the plurality of second electrodes in the same pixel and penetrating the third semiconductor layer, the first semiconductor layer, and the second semiconductor layer; and
a wiring layer electrically connecting the plurality of second electrodes in the same pixel to the corresponding via.

The photoelectric conversion element may further include a via provided for a plurality of pixels, electrically connected to the plurality of second electrodes in the plurality of pixels, and penetrating the third semiconductor layer, the first semiconductor layer, and the second semiconductor layer, and
all the second electrodes in the plurality of pixels may be electrically connected to the via.

The photoelectric conversion element may further include a first readout circuit disposed on the side of the second semiconductor layer opposite to the light incidence surface and electrically connected to the first electrode;
a via electrically connected to the second electrode and penetrating the third semiconductor layer, the first semiconductor layer, and the second semiconductor layer; and
a second readout circuit disposed on the side of the second semiconductor layer opposite to the light incidence surface and electrically connected to the via.

The photoelectric conversion element may further include a first substrate on which the first semiconductor layer, the second semiconductor layer, the third semiconductor layer, the first diffusion layer, the second diffusion layer, the first electrode, and the second electrode are arranged;
a second substrate on which the first readout circuit and the second readout circuit are arranged, and a readout circuit that generates a pixel signal based on charges taken out by the first readout circuit and charges taken out by the second readout circuit is arranged; and
a plurality of bonding portions that bonds the first substrate and the second substrate and transmits and receives a plurality of signals between the first substrate and the second substrate, and
the via may be connected to the corresponding bonding portion.

The photoelectric conversion element may further include a first substrate on which the first semiconductor layer, the second semiconductor layer, the third semiconductor layer, the first diffusion layer, the second diffusion layer, the first electrode, and the second electrode are arranged; and
a second substrate on which the first readout circuit and the second readout circuit are arranged, and which generates a pixel signal based on charges taken out by the first readout circuit and charges taken out by the second readout circuit, and
the via may extend through the first substrate to the second readout circuit in the second substrate.

A voltage applied to the first readout circuit may be set independently of a voltage applied to the second readout circuit.

The via may include:
a first via that transfers first charges generated by photoelectric conversion to the second readout circuit; and
a second via that discharges second charges generated by photoelectric conversion.

The first via and the second via may be provided for every plurality of pixels,
the first via may discharge the first charges of the corresponding plurality of pixels, and
the second via may discharge the second charges of the corresponding plurality of pixels.

The second diffusion layer may be arranged to penetrate the third semiconductor layer from a light incidence surface side of the third semiconductor layer and extend into the first semiconductor layer.

The first electrode and the second electrode may collect charges obtained by photoelectrically converting light in the same wavelength band.

The second diffusion layer may be arranged so as to remain inside the third semiconductor layer without penetrating the third semiconductor layer from the light incidence surface side of the third semiconductor layer.

The first electrode and the second electrode may collect charges obtained by photoelectrically converting light in different wavelength bands.

The photoelectric conversion element may further include a barrier layer disposed between the first semiconductor layer and the third semiconductor layer to block charges generated by photoelectric conversion in the third semiconductor layer.

The barrier layer may contain a material with a larger band gap than the third semiconductor layer.

The barrier layer may contain the same material as the third semiconductor layer and contain more impurities of the same conductivity type as the third semiconductor layer than the third semiconductor layer.

The barrier layer may contain a different material from the third semiconductor layer and contain more impurities of the same conductivity type as the third semiconductor layer than the third semiconductor layer.

The photoelectric conversion element may further include a third via penetrating the third semiconductor layer and extending to the barrier layer.

The third via may discharge charges that are generated by photoelectric conversion in the first semiconductor layer but are not to be read out to the light incidence surface side.

The photoelectric conversion element may further include a fourth via that discharges the charges transferred to the light incidence surface side through the third via to a side opposite to the light incidence surface.

The photoelectric conversion element may further include a transparent electrode layer that is in contact with a portion of the barrier layer and is disposed on the light incidence surface side of the third semiconductor layer.

The photoelectric conversion element may further include a hole arranged to penetrate the third semiconductor layer, and
the transparent electrode layer may be arranged to cover a side wall surface of the hole and a surface of the barrier layer arranged at a bottom of the hole.

The hole may be provided according to a location of the pixel, and
a diameter of the hole may correspond to a size of one pixel.

The photoelectric conversion element may further include a pixel separation layer arranged to penetrate the first semiconductor layer and the third semiconductor layer along a pixel boundary region.

The compound semiconductor material of the second semiconductor layer may be the same as the compound semiconductor material of the third semiconductor layer.

The photoelectric conversion element may further include: a fourth semiconductor layer of the first conductivity type, which is disposed on the light incidence surface side of the third semiconductor layer, has a higher impurity concentration than the third semiconductor layer, and is disposed electrically separated from the second electrode; and
a third electrode made of a transparent electrode material and electrically connected to the fourth semiconductor layer.

According to the present disclosure, there is provided an imaging device including a pixel array unit having a plurality of pixels, each of the plurality of pixels includes:
a first semiconductor layer of a first conductivity type containing a compound semiconductor material that performs photoelectric conversion;
a second semiconductor layer of a first conductivity type containing a compound semiconductor material having a larger band gap than the first semiconductor layer and stacked on a side of the first semiconductor layer opposite to the light incidence surface;
a third semiconductor layer of a first conductivity type containing a compound semiconductor material having a larger band gap than the first semiconductor layer and stacked on the light incidence surface side of the first semiconductor layer;
a first diffusion layer of a second conductivity type disposed to penetrate the second semiconductor layer from a side of the second semiconductor layer opposite to the light incidence surface and extend into the first semiconductor layer;
a first electrode in contact with the first diffusion layer on the side of the second semiconductor layer opposite to the light incidence surface;
a second diffusion layer of a second conductivity type disposed in a depth direction of the third semiconductor layer from a light incidence surface side of the third semiconductor layer;
a second electrode in contact with the second diffusion layer on the light incidence surface side of the third semiconductor layer; and
an insulating layer disposed between the second electrode and the third semiconductor layer.

### [Brief Description of Drawings]

[Fig. 1]

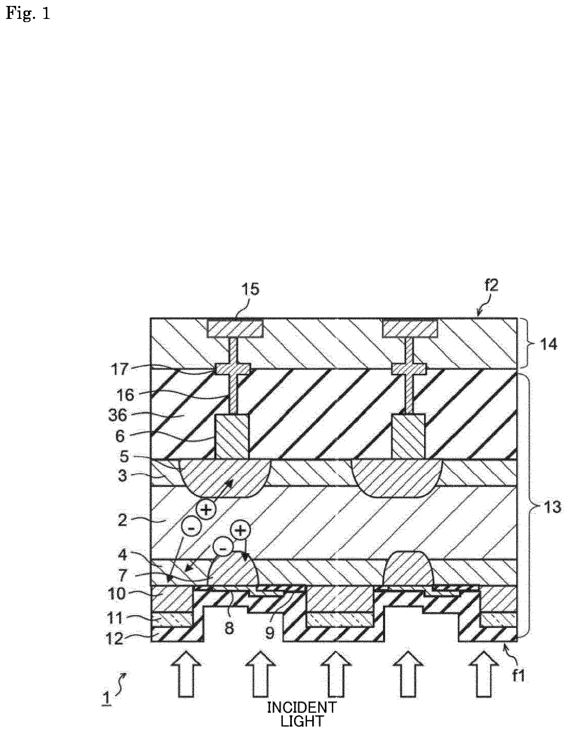

   Fig. 1 is a cross-sectional view of a photoelectric conversion element according to a first embodiment.
[Fig. 2]

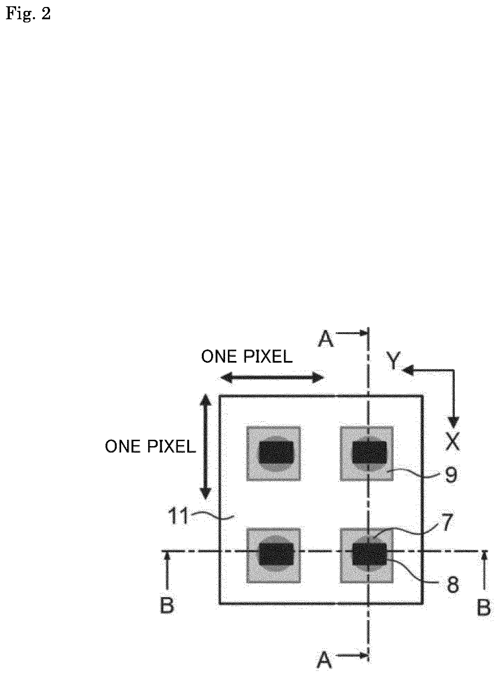

   Fig. 2 is a plan view of the photoelectric conversion element in Fig. 1, viewed from the light incidence surface side.
[Fig. 3]

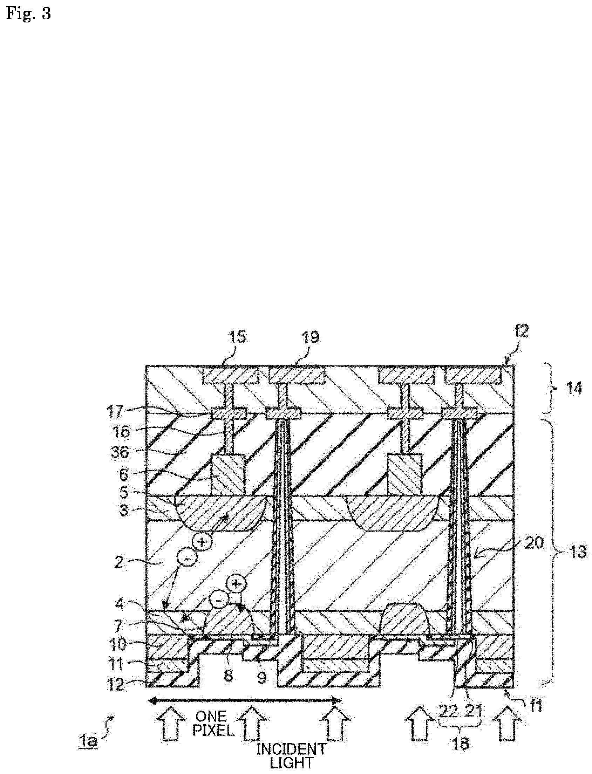

   Fig. 3 is a cross-sectional view of a photoelectric conversion element according to a second embodiment.
[Fig. 4]

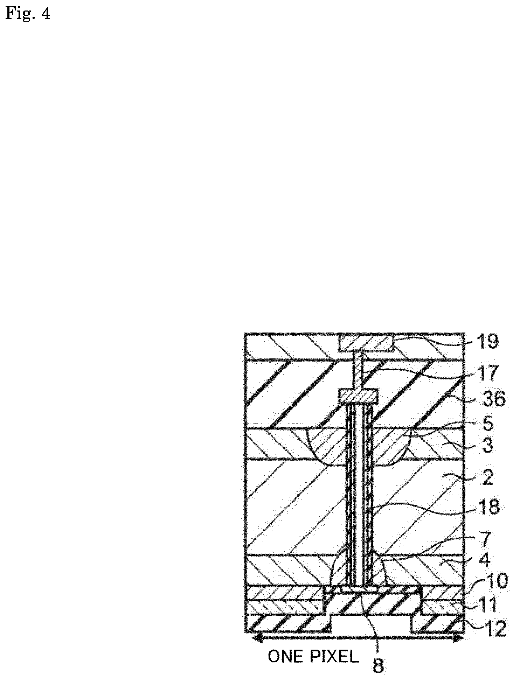

   Fig. 4 is a cross-sectional view taken along line B-B in Fig. 2.
[Fig. 5]

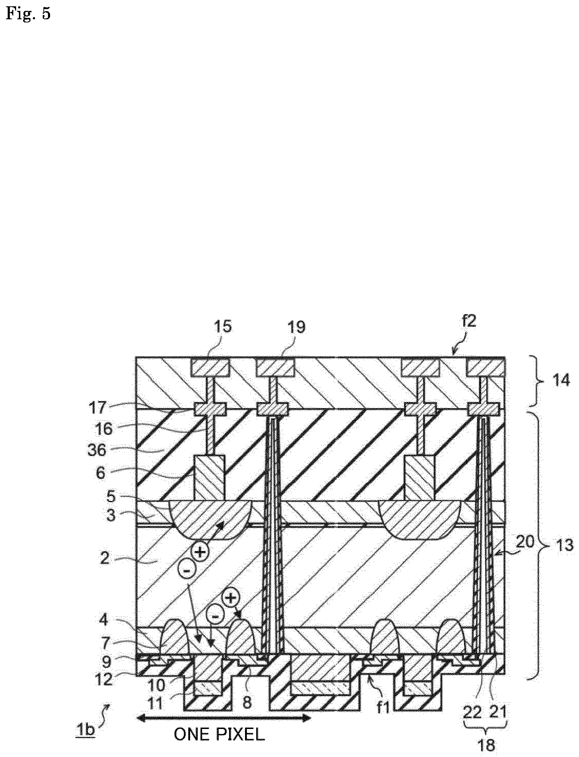

   Fig. 5 is a cross-sectional view of a photoelectric conversion element according to a third embodiment.
[Fig. 6]

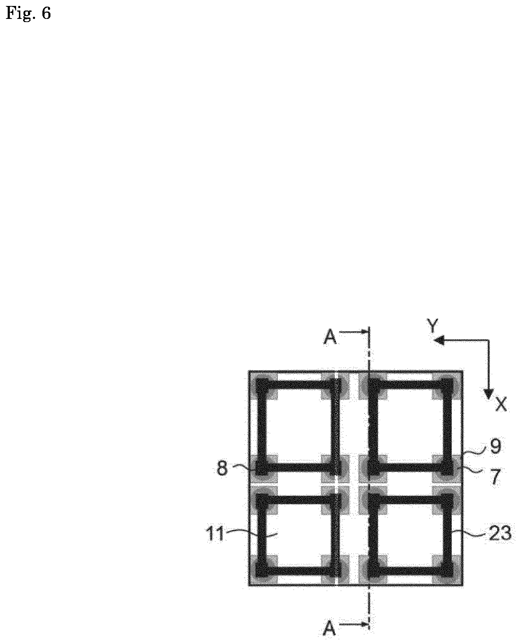

   Fig. 6 is a plan view seen from the light incidence surface side of Fig. 5.
[Fig. 7]

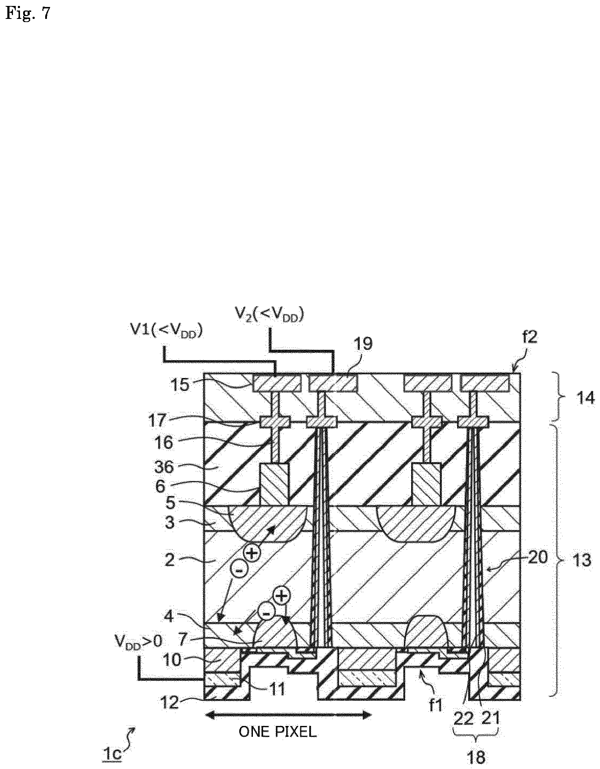

   Fig. 7 is a cross-sectional view of a photoelectric conversion element according to a fourth embodiment.
[Fig. 8]

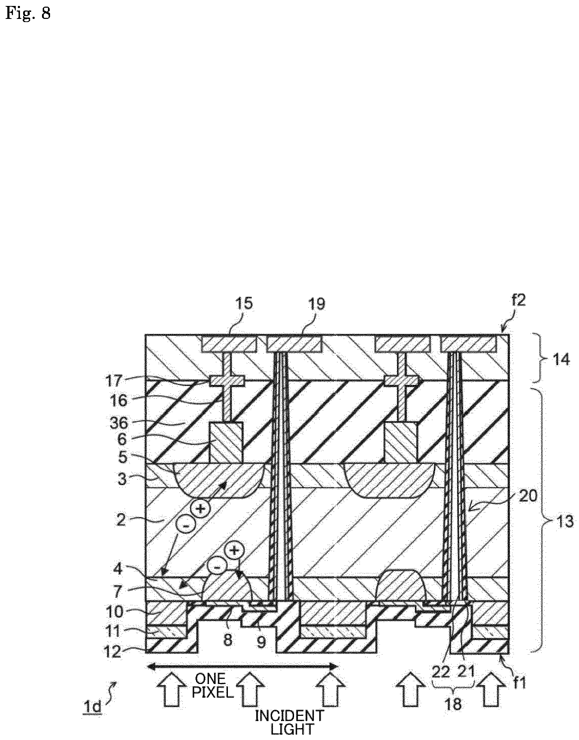

   Fig. 8 is a cross-sectional view of a photoelectric conversion element according to a fifth embodiment.
[Fig. 9]

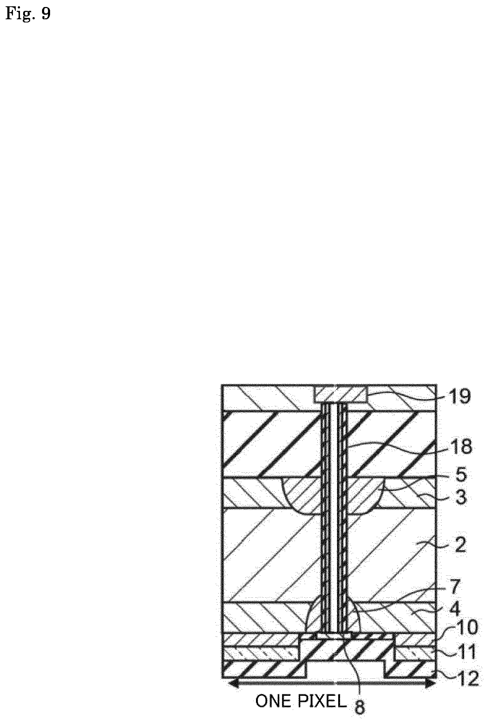

   Fig. 9 is a cross-sectional view taken along line B-B in Fig. 2.
[Fig. 10]

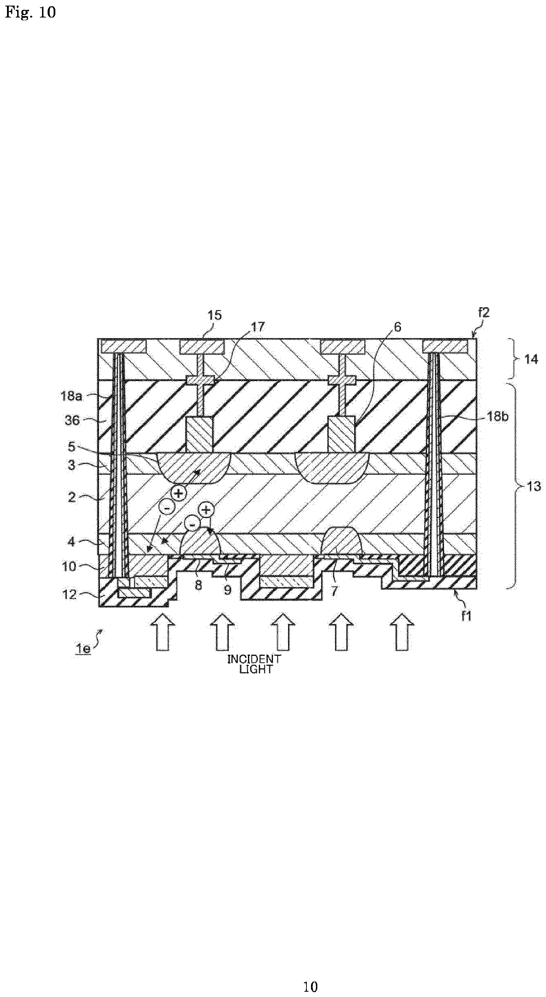

   Fig. 10 is a cross-sectional view of a photoelectric conversion element according to a sixth embodiment.
[Fig. 11]

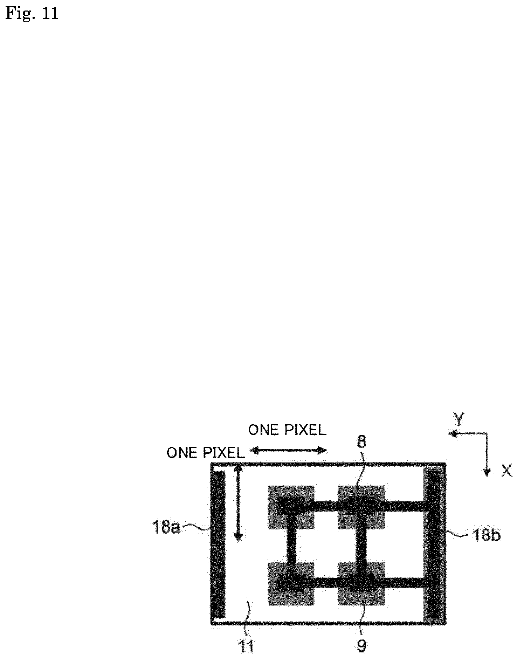

   Fig. 11 is a plan view of the photoelectric conversion element illustrated in Fig. 10, viewed from the light incidence surface side.
[Fig. 12A]

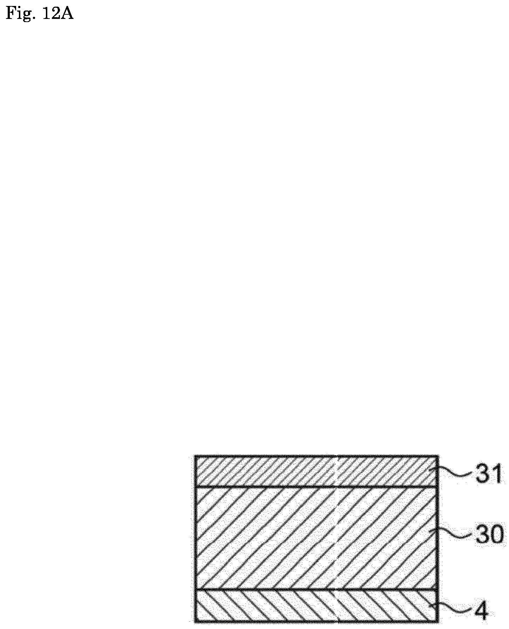

   Fig. 12A is a process diagram illustrating the manufacturing process of the photoelectric conversion element of Fig. 3.
[Fig. 12B]

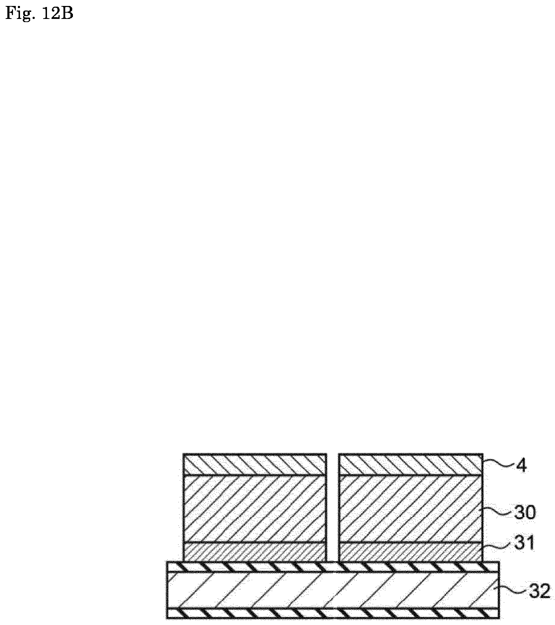

   Fig. 12B is a process diagram, which is continuous with Fig. 12A.
[Fig. 12C]

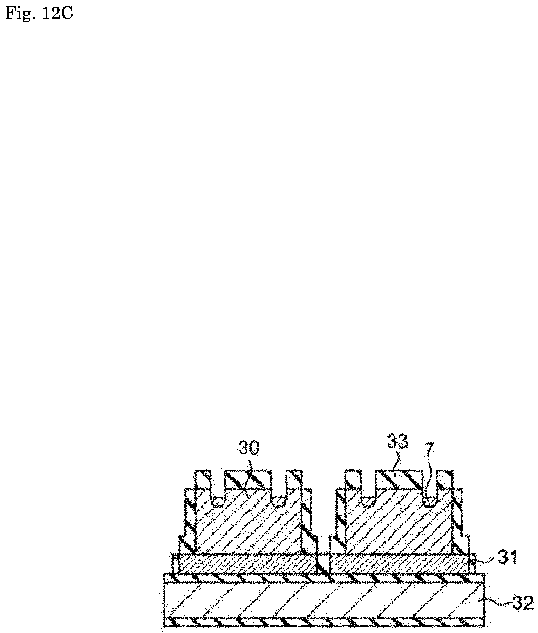

   Fig. 12C is a process diagram, which is continuous with Fig. 12B.
[Fig. 12D]

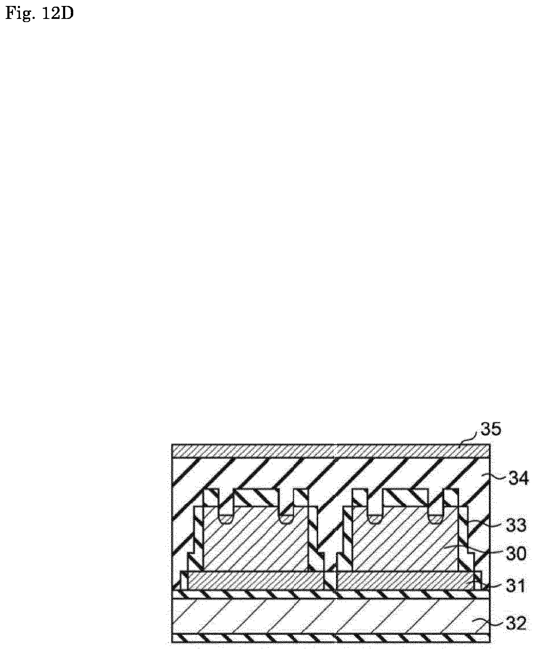

   Fig. 12D is a process diagram, which is continuous with Fig. 12C.
[Fig. 12E]

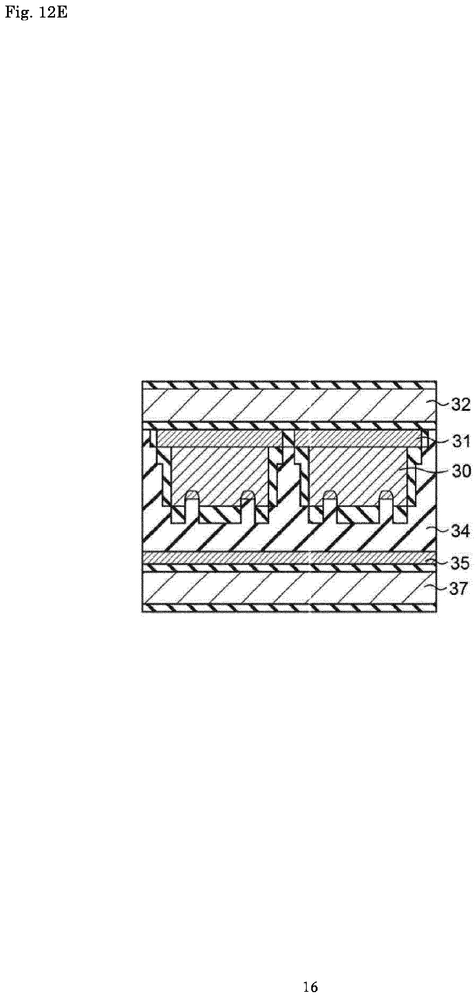

   Fig. 12E is a process diagram, which is continuous with Fig. 12D.
[Fig. 12F]

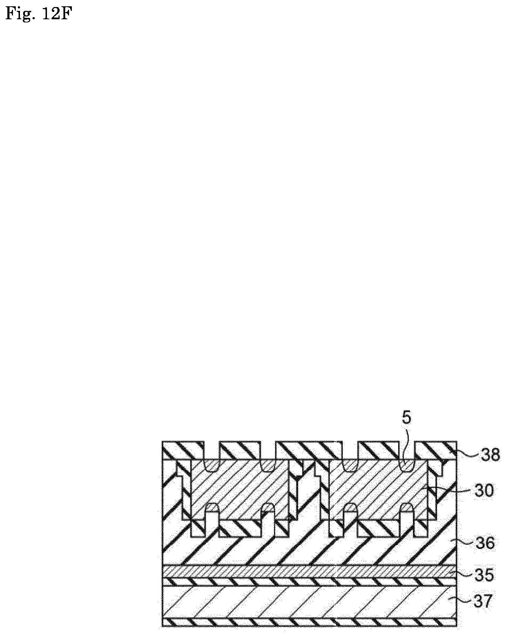

   Fig. 12F is a process diagram, which is continuous with Fig. 12E.
[Fig. 12G]

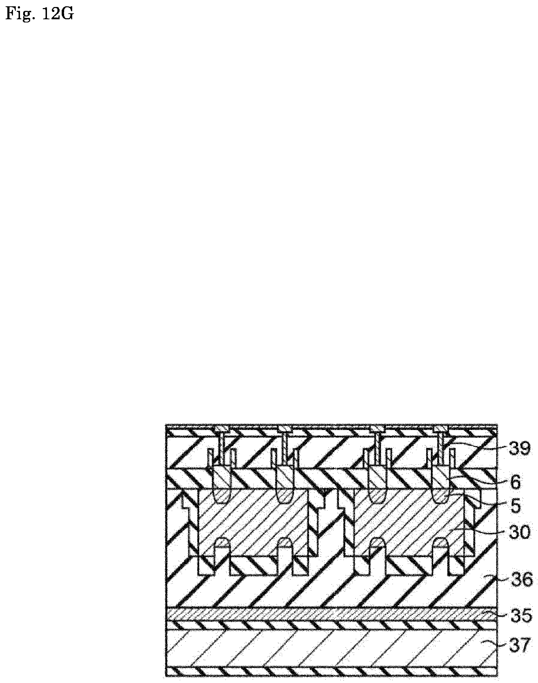

   Fig. 12G is a process diagram, which is continuous with Fig. 12F.
[Fig. 12H]

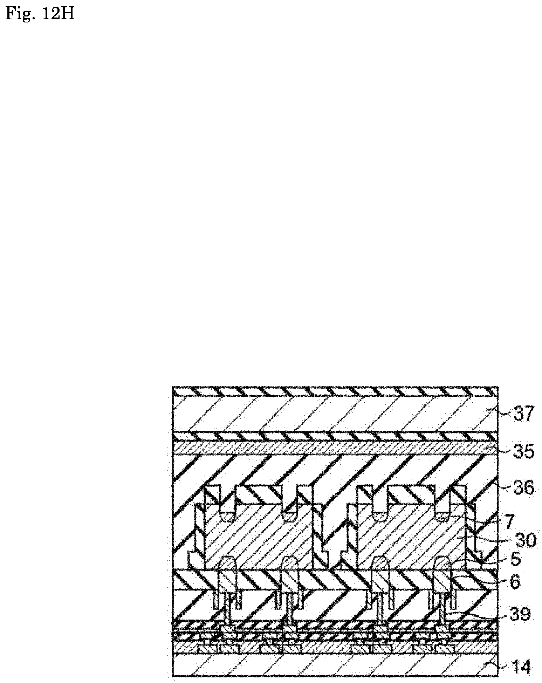

   Fig. 12H is a process diagram, which is continuous with Fig. 12G.
[Fig. 12I]

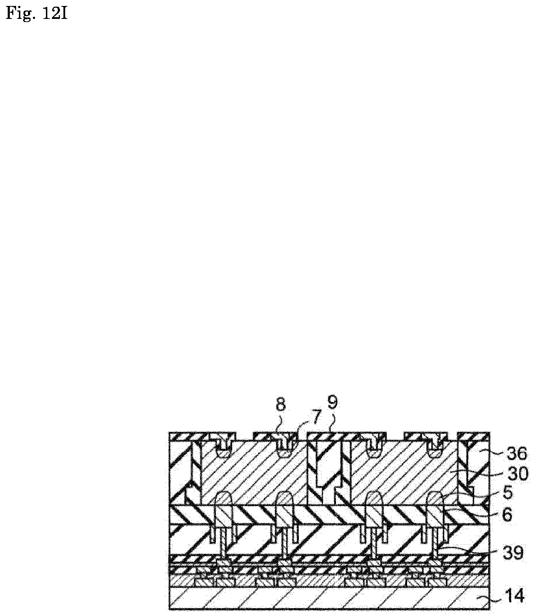

   Fig. 12I is a process diagram, which is continuous with Fig. 12H.
[Fig. 13]

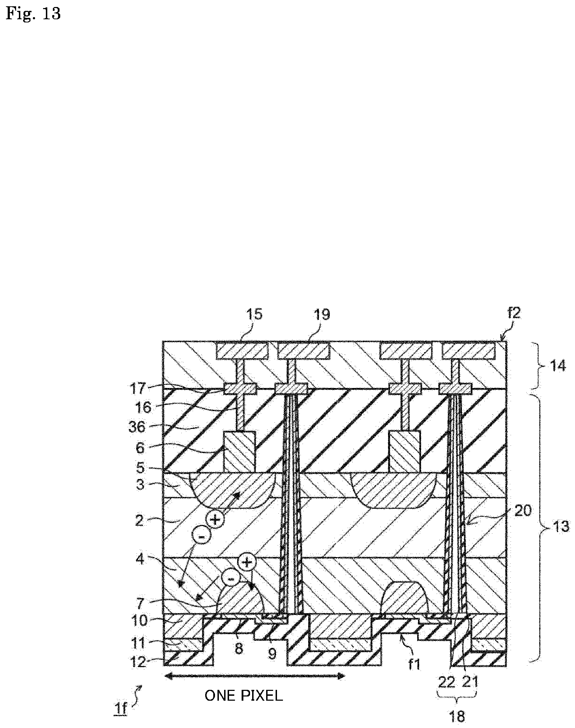

   Fig. 13 is a cross-sectional view of a photoelectric conversion element according to an eighth embodiment.
[Fig. 14]

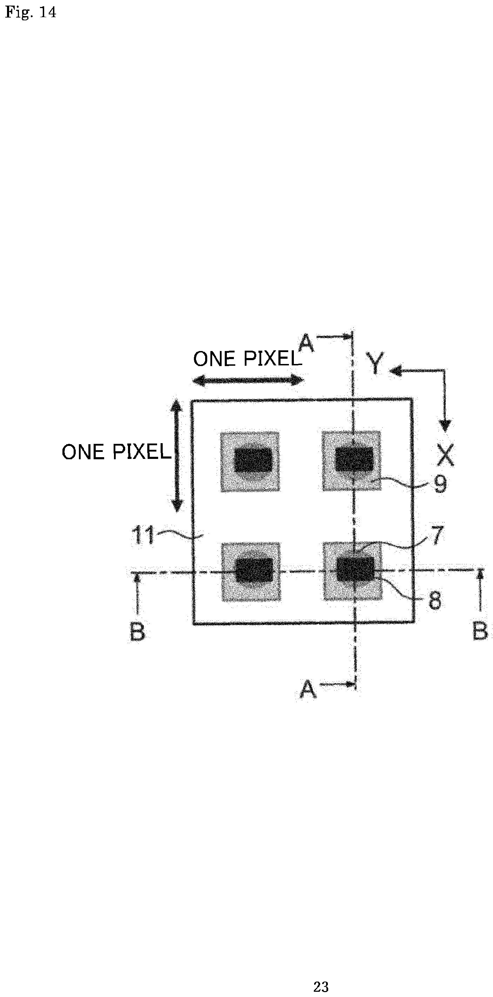

   Fig. 14 is a plan view of the photoelectric conversion element illustrated in Fig. 13, viewed from the light incidence surface side.
[Fig. 15]

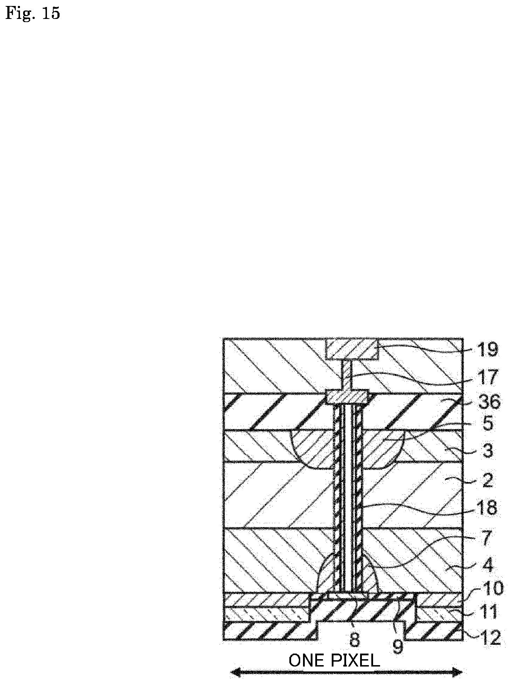

   Fig. 15 is a cross-sectional view taken along line B-B in Fig. 14.
[Fig. 16]

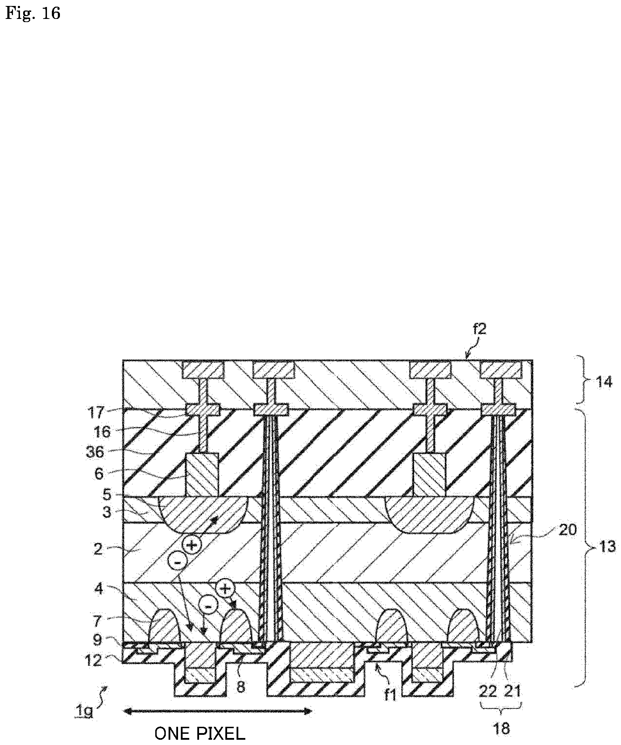

   Fig. 16 is a cross-sectional view of a photoelectric conversion element according to a ninth embodiment.
[Fig. 17]

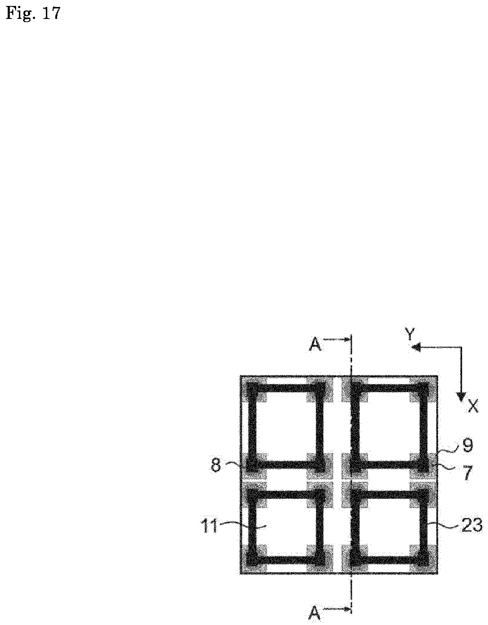

   Fig. 17 is a plan view of the photoelectric conversion element illustrated in Fig. 16, viewed from the light incidence surface side.
[Fig. 18]

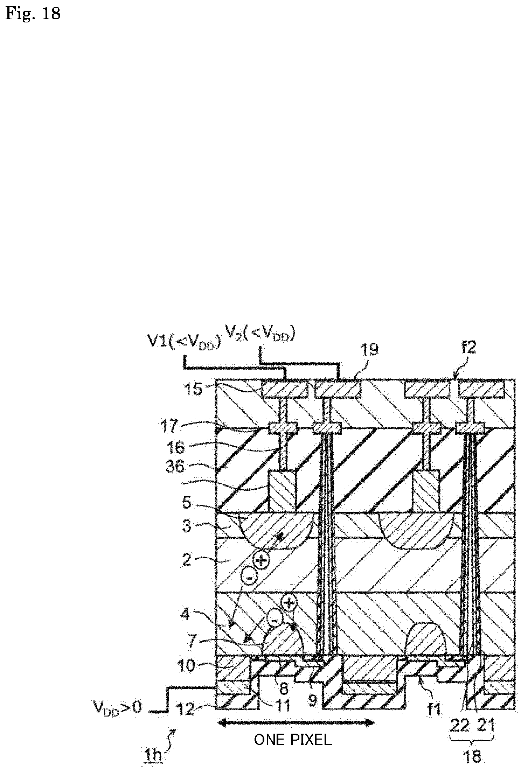

   Fig. 18 is a cross-sectional view of a photoelectric conversion element according to a tenth embodiment.
[Fig. 19]

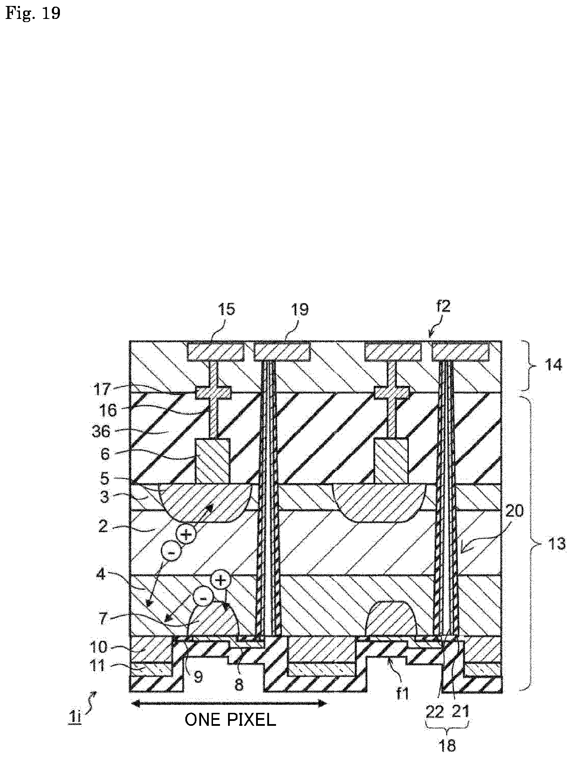

   Fig. 19 is a cross-sectional view of a photoelectric conversion element according to an eleventh embodiment.
[Fig. 20]

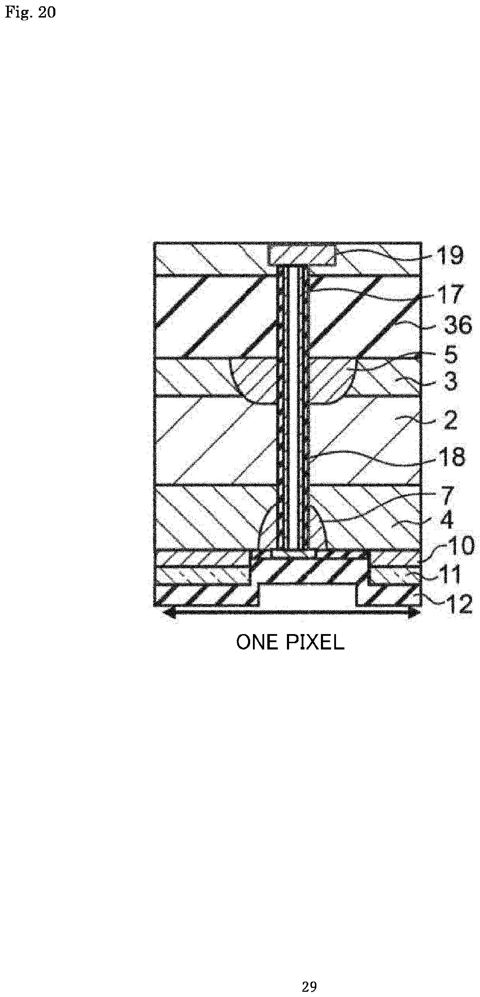

   Fig. 20 is a cross-sectional view taken along line B-B in Fig. 14.
[Fig. 21]

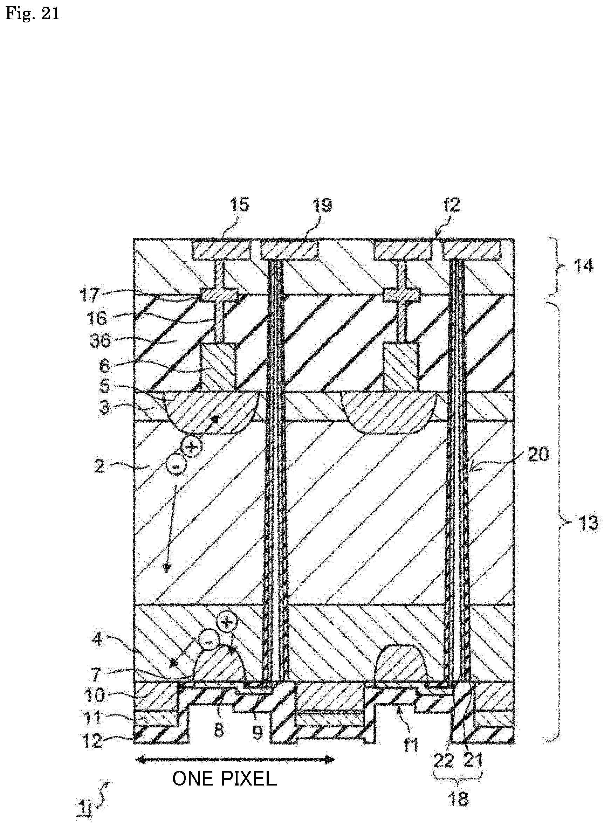

   Fig. 21 is a cross-sectional view of a photoelectric conversion element according to a twelfth embodiment.
[Fig. 22]

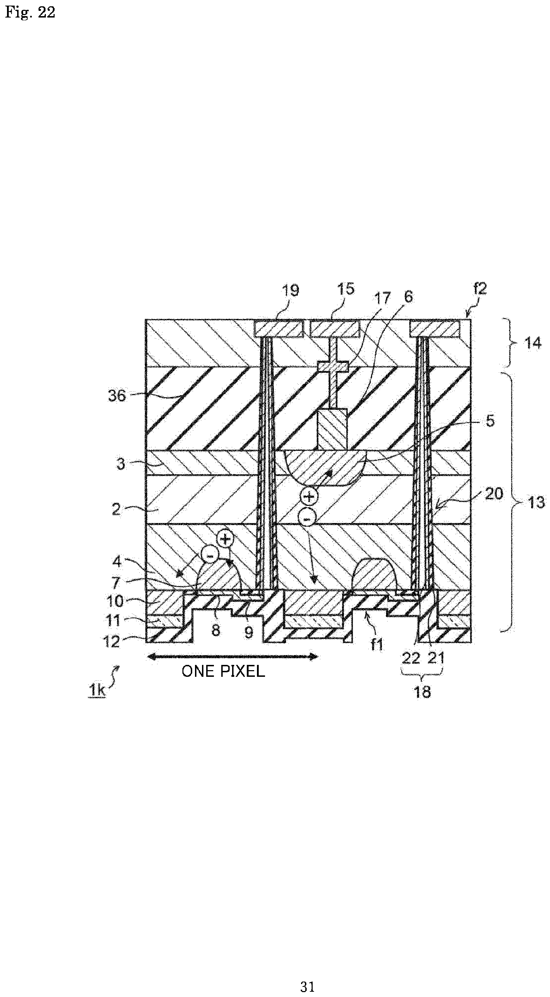

   Fig. 22 is a cross-sectional view of a photoelectric conversion element according to a thirteenth embodiment.
[Fig. 23]

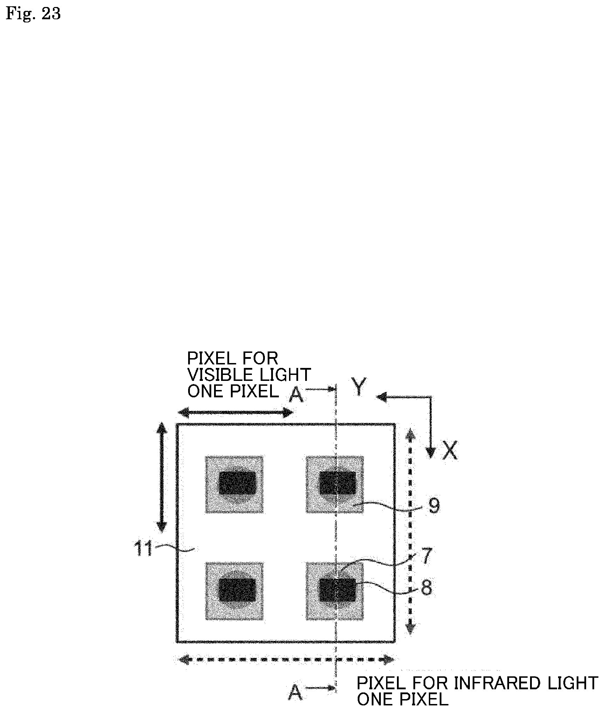

   Fig. 23 is a plan view of the photoelectric conversion element illustrated in Fig. 22, viewed from the light incidence surface side.
[Fig. 24]

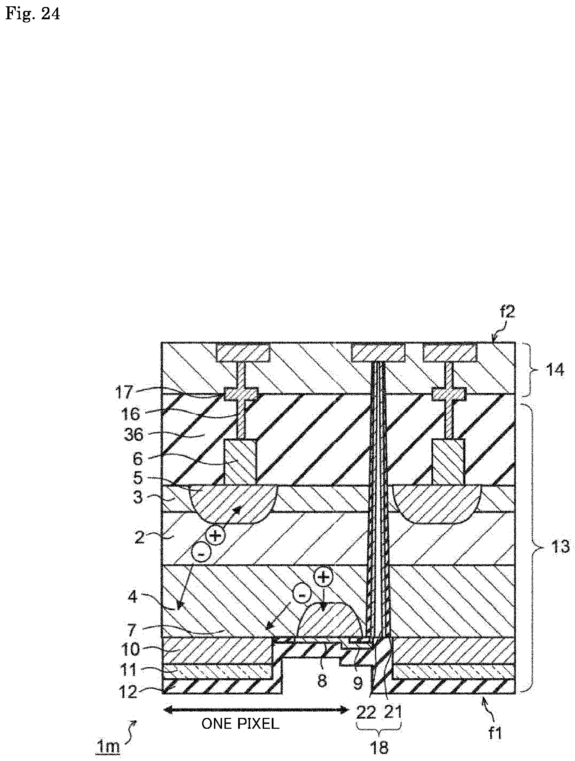

   Fig. 24 is a cross-sectional view of a photoelectric conversion element according to a modified example of Fig. 22.
[Fig. 25]

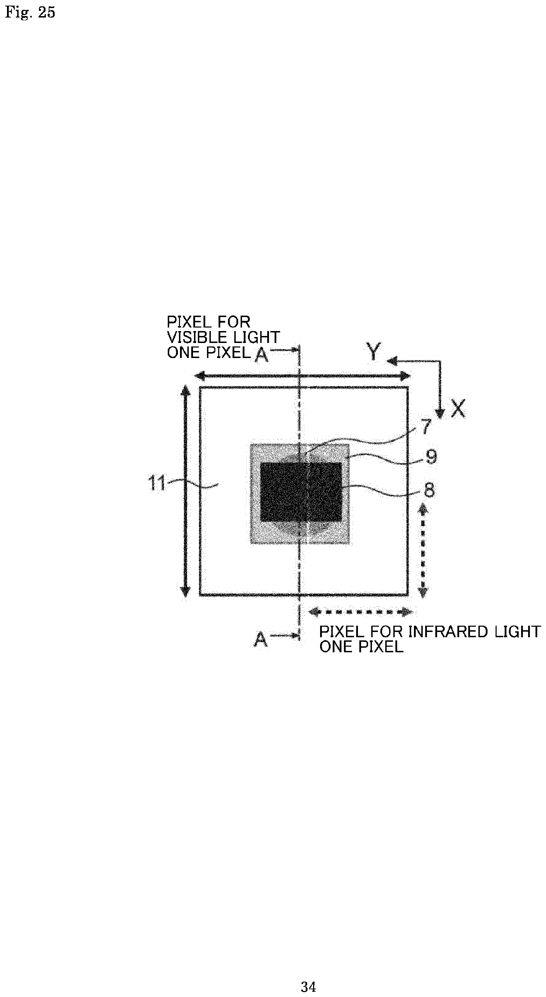

   Fig. 25 is a plan view of the photoelectric conversion element illustrated in Fig. 24, viewed from the light incidence surface side.
[Fig. 26]

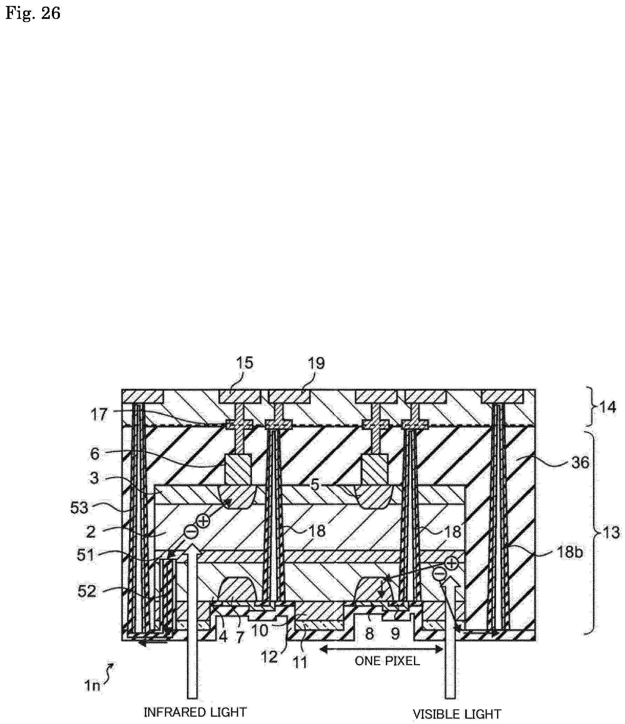

   Fig. 26 is a cross-sectional view of a photoelectric conversion element according to a fourteenth embodiment.
[Fig. 27]

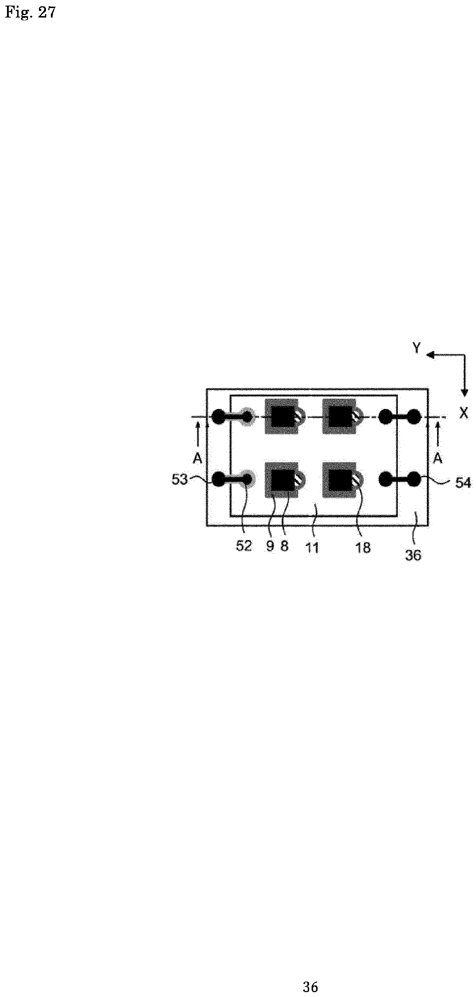

   Fig. 27 is a plan view of the photoelectric conversion element illustrated in Fig. 26, viewed from the light incidence surface side.
[Fig. 28]

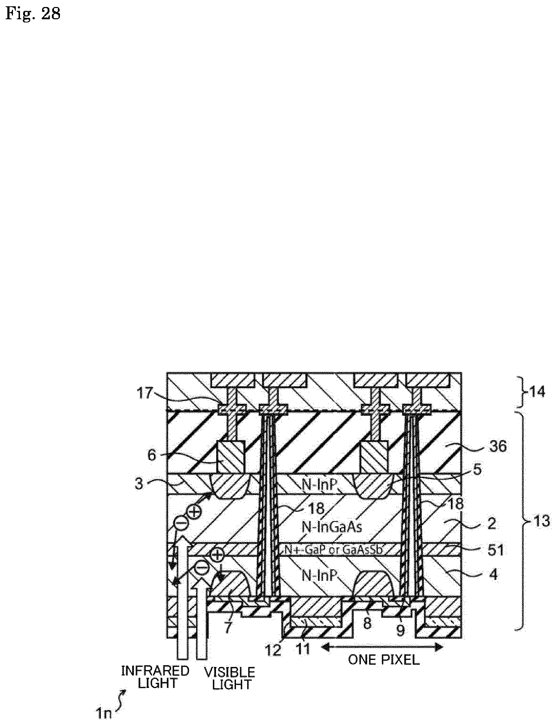

   Fig. 28 is a cross-sectional view illustrating a first specific example of the photoelectric conversion element according to the fourteenth embodiment.
[Fig. 29]

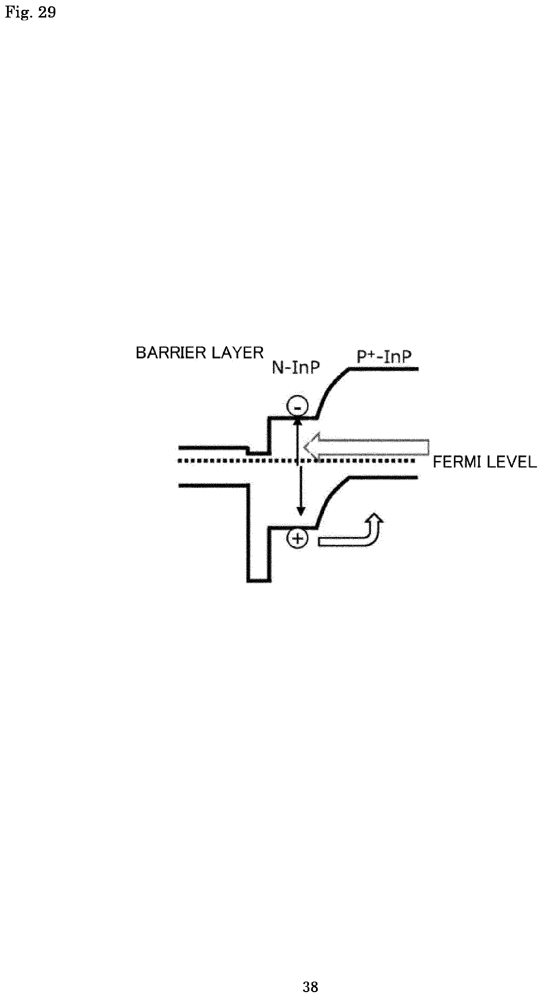

   Fig. 29 is a potential diagram of the photoelectric conversion element in Fig. 28.
[Fig. 30]

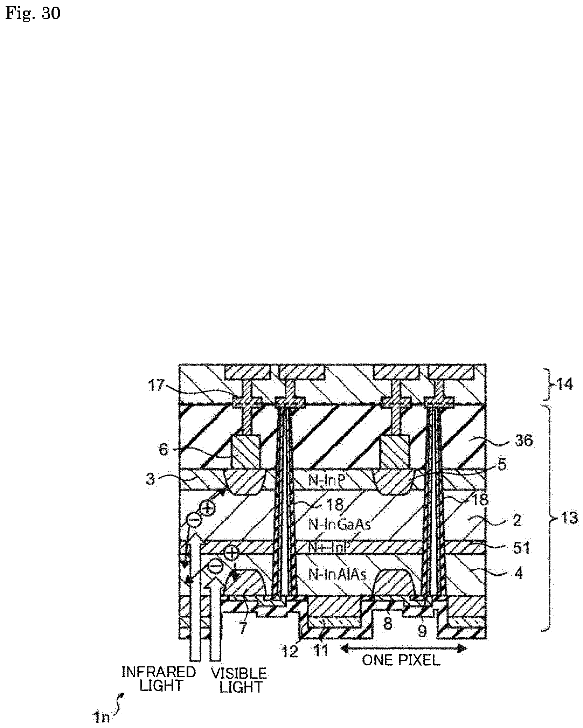

   Fig. 30 is a cross-sectional view illustrating a second specific example of the photoelectric conversion element according to the fourteenth embodiment.
[Fig. 31]

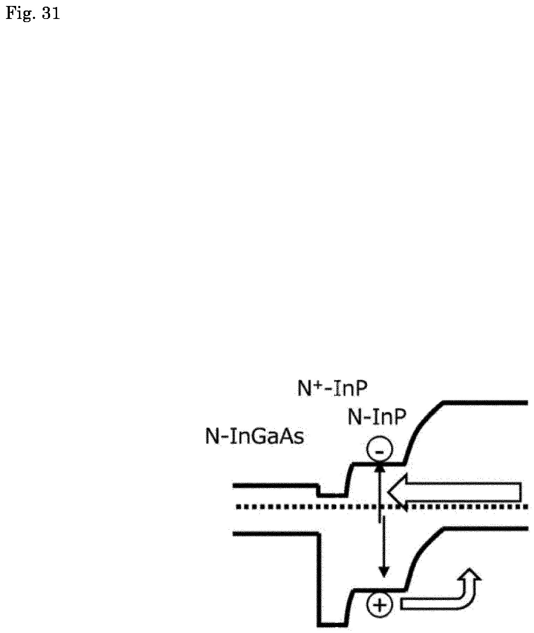

   Fig. 31 is a potential diagram of the photoelectric conversion element in Fig. 30.
[Fig. 32]

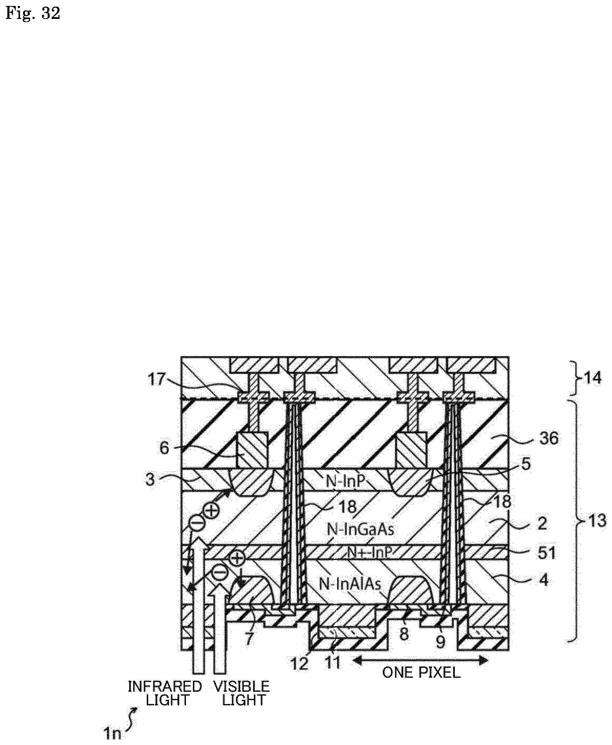

   Fig. 32 is a circuit diagram illustrating a third specific example of the photoelectric conversion element according to the fourteenth embodiment.
[Fig. 33]

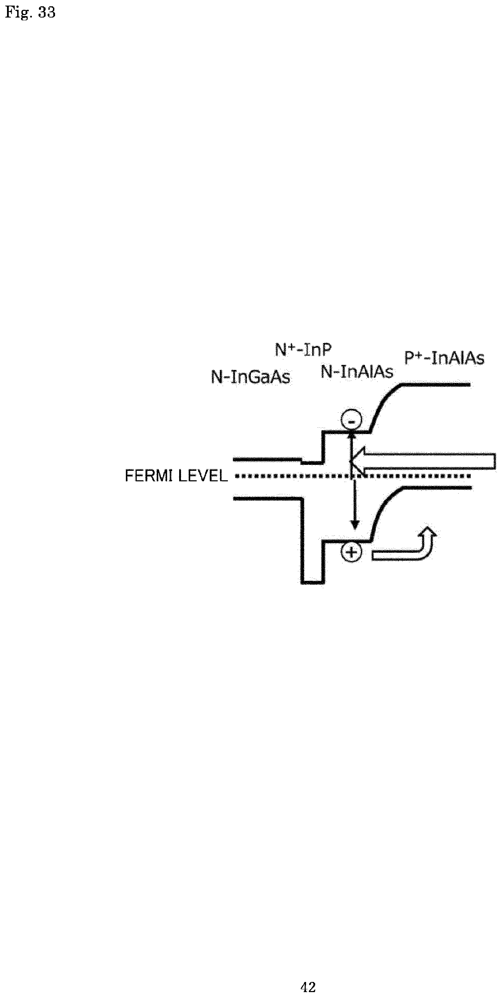

   Fig. 33 is a potential diagram of the photoelectric conversion element in Fig. 32.
[Fig. 34]

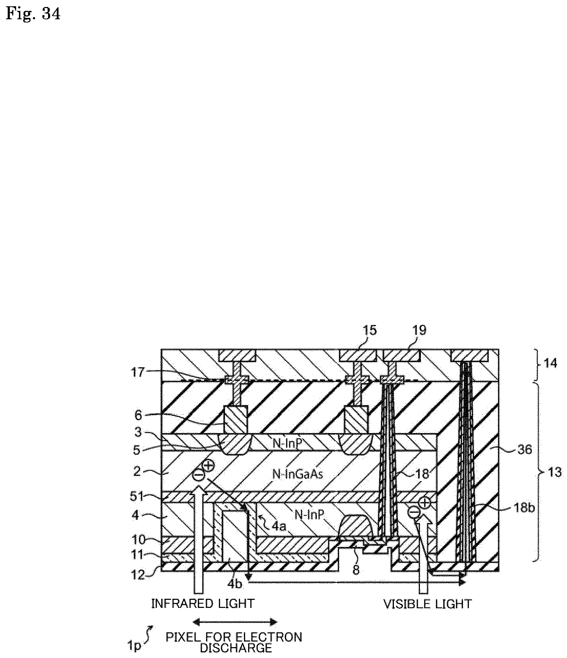

   Fig. 34 is a cross-sectional view of a photoelectric conversion element according to a fifteenth embodiment.
[Fig. 35]

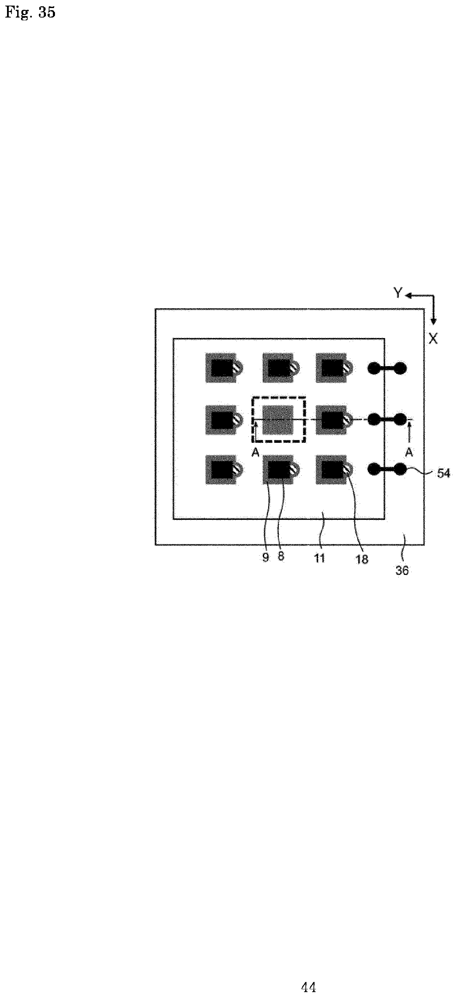

   Fig. 35 is a plan view of the photoelectric conversion element illustrated in Fig. 34, viewed from the light incidence surface side.
[Fig. 36]

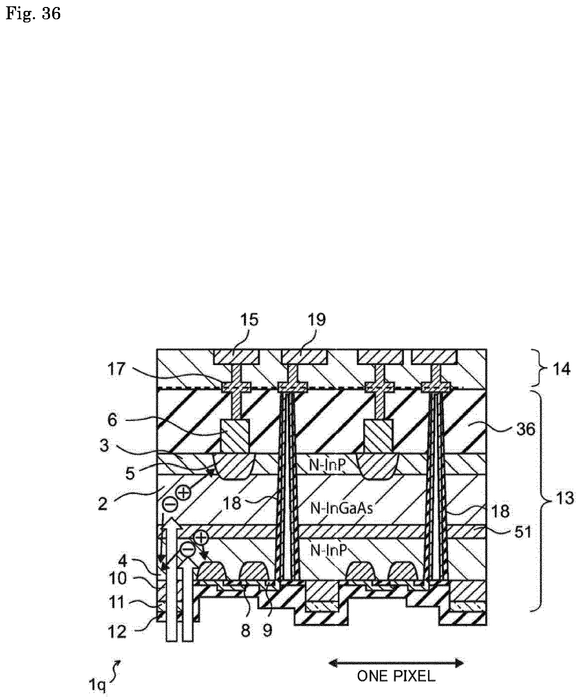

   Fig. 36 is a cross-sectional view of a photoelectric conversion element according to a sixteenth embodiment.
[Fig. 37]

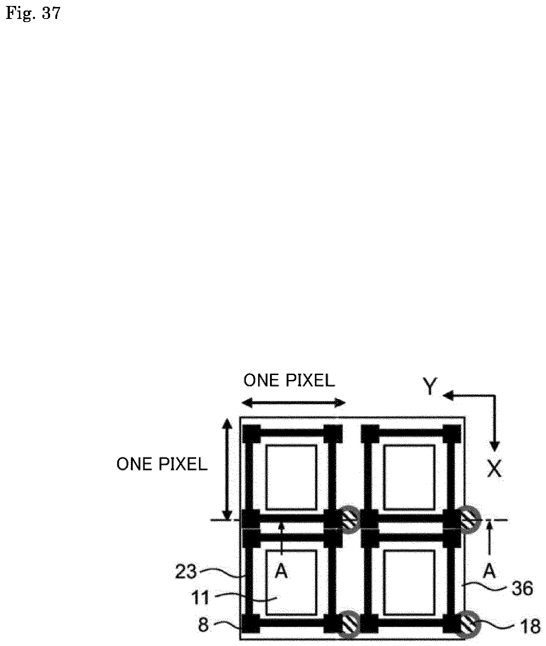

   Fig. 37 is a plan view of the photoelectric conversion element illustrated in Fig. 36, viewed from the light incidence surface side.
[Fig. 38]

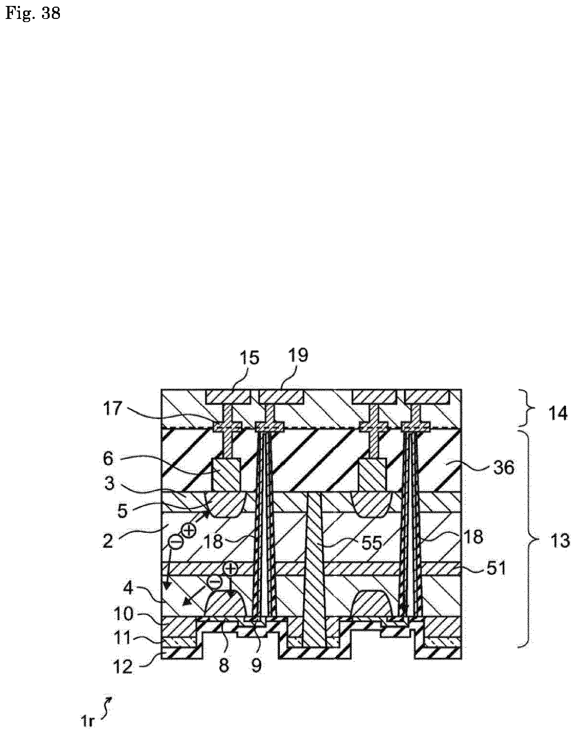

   Fig. 38 is a cross-sectional view of a photoelectric conversion element according to a seventeenth embodiment.
[Fig. 39]

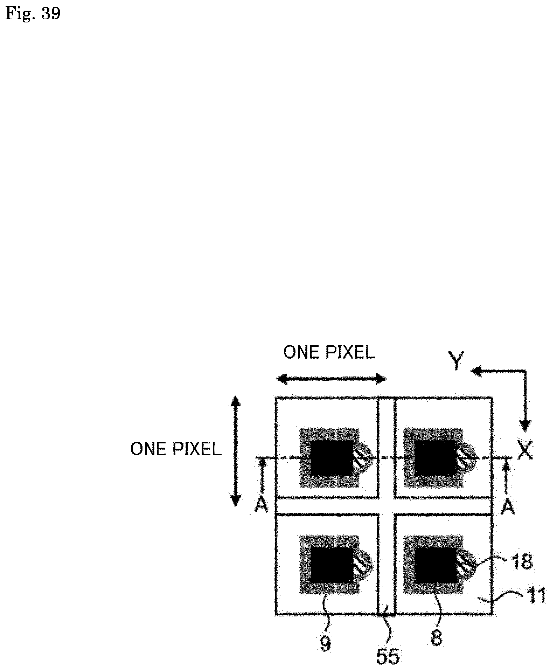

   Fig. 39 is a plan view of the photoelectric conversion element illustrated in Fig. 38, viewed from the light incidence surface side.
[Fig. 40A]

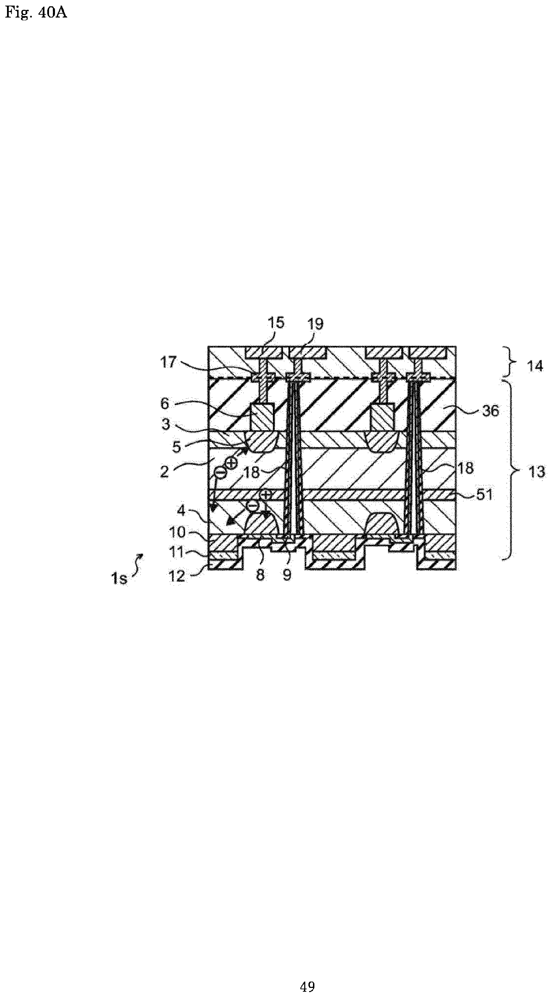

   Fig. 40A is a cross-sectional view of a photoelectric conversion element according to a modified example of Fig. 38.
[Fig. 40B]

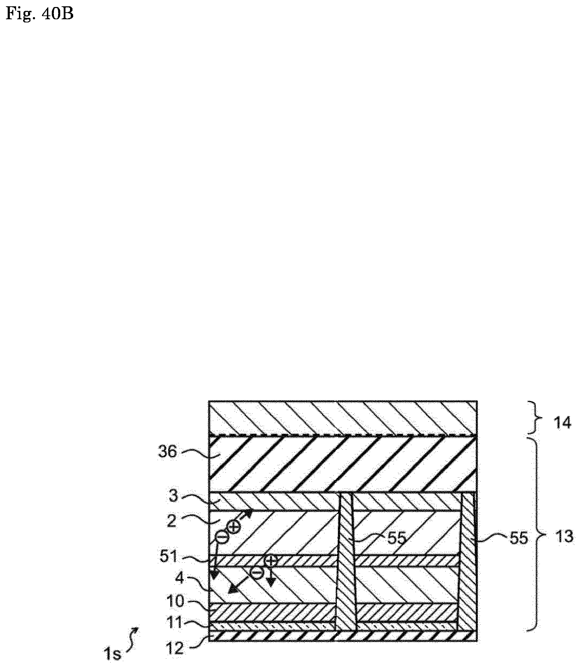

   Fig. 40B is a cross-sectional view of a photoelectric conversion element according to a modified example of Fig. 38.
[Fig. 41]

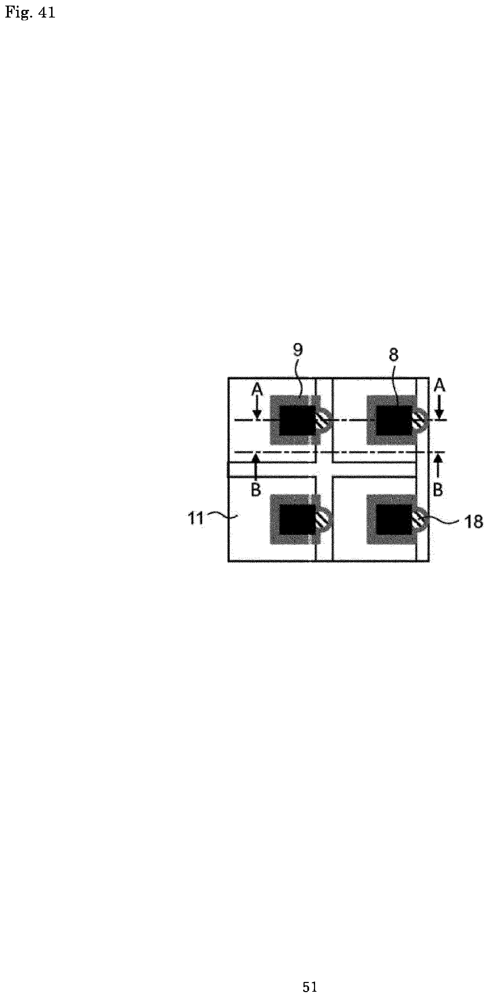

   Fig. 41 is a plan view of the photoelectric conversion element illustrated in Fig. 40, viewed from the light incidence surface side.
[Fig. 42]

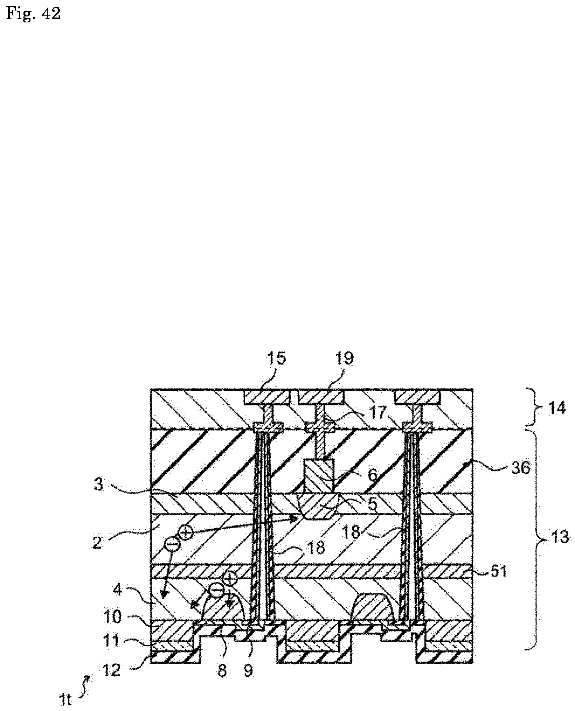

   Fig. 42 is a cross-sectional view of a photoelectric conversion element according to an eighteenth embodiment.
[Fig. 43]

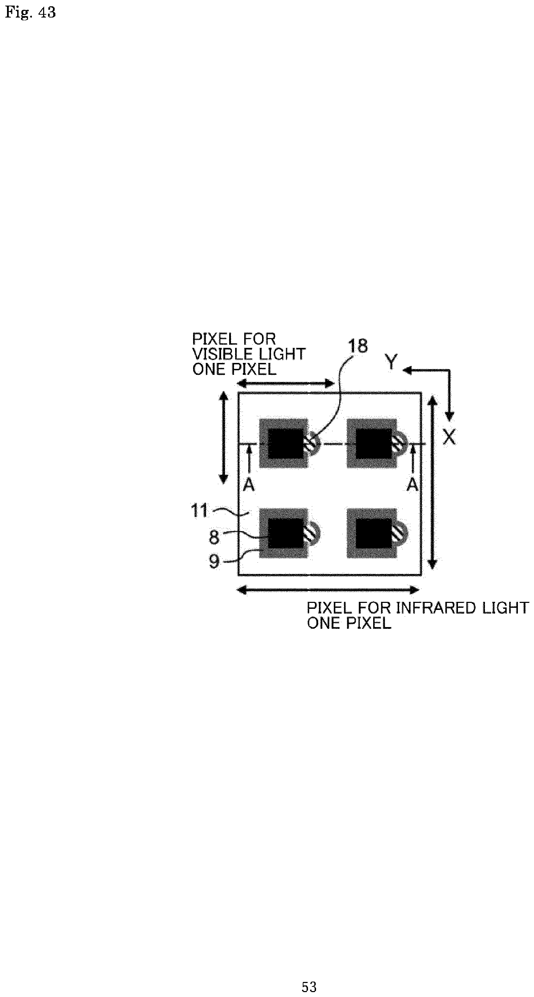

   Fig. 43 is a plan view of the photoelectric conversion element illustrated in Fig. 42, viewed from the light incidence surface side.
[Fig. 44]

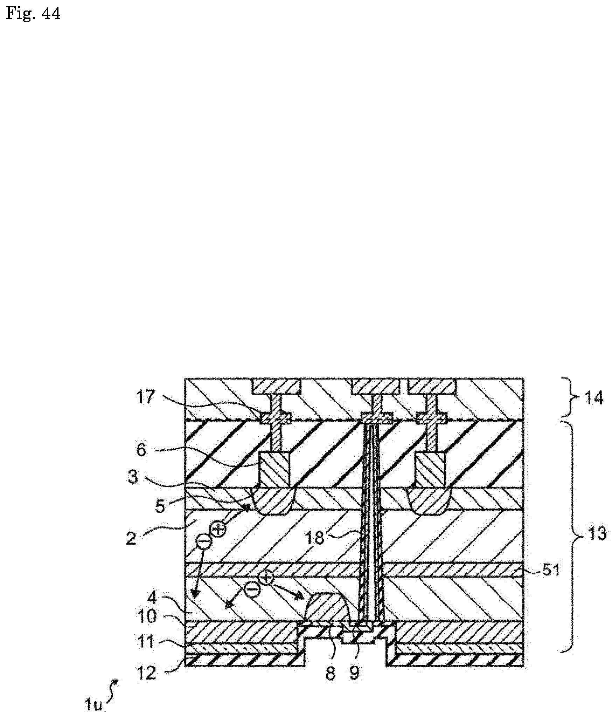

   Fig. 44 is a cross-sectional view of a photoelectric conversion element according to a modified example of Fig. 42.
[Fig. 45]

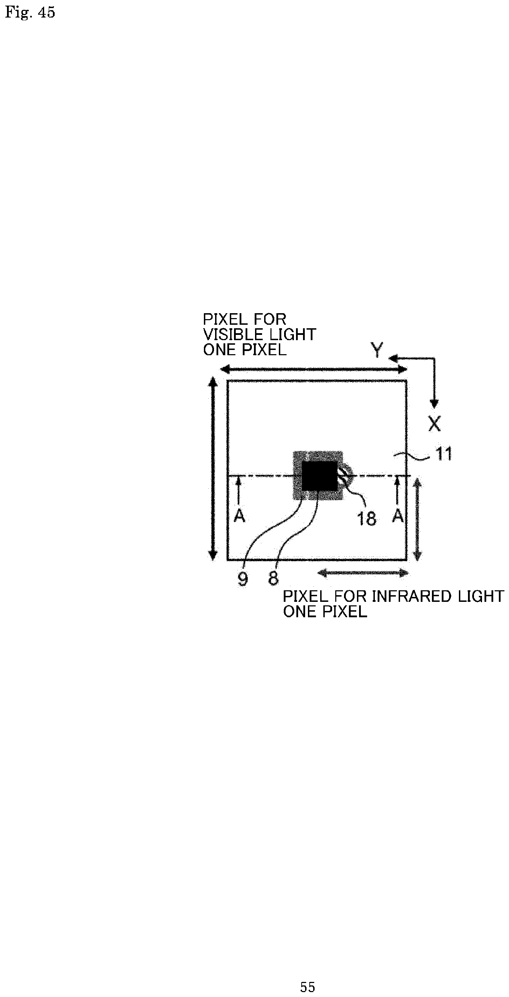

   Fig. 45 is a plan view of the photoelectric conversion element illustrated in Fig. 44, viewed from the light incidence surface side.
[Fig. 46]

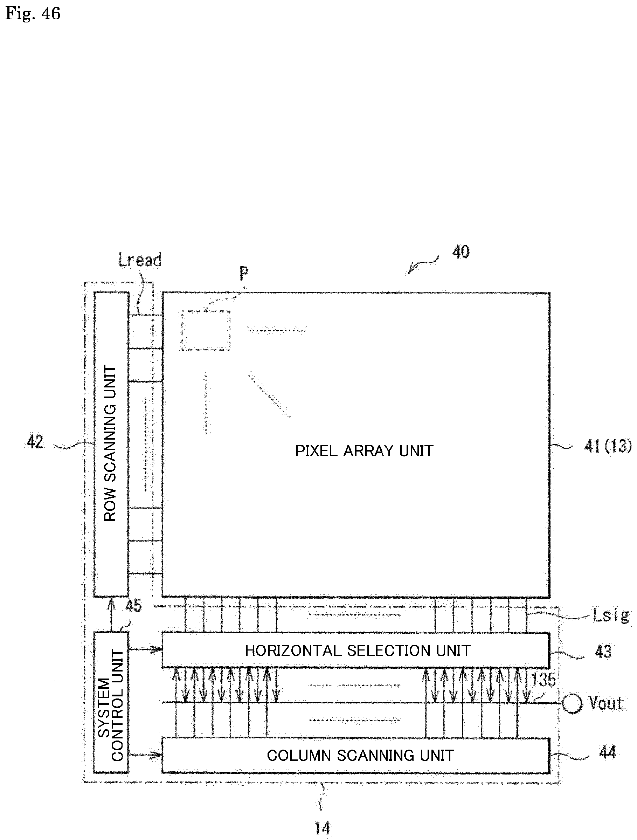

   Fig. 46 is a block diagram illustrating a schematic configuration of an imaging device.
[Fig. 47]

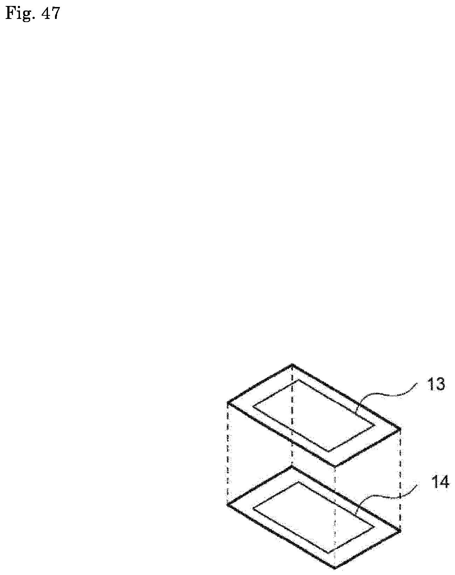

   Fig. 47 is a diagram schematically illustrating how a first substrate and a second substrate are bonded together.
[Fig. 48]

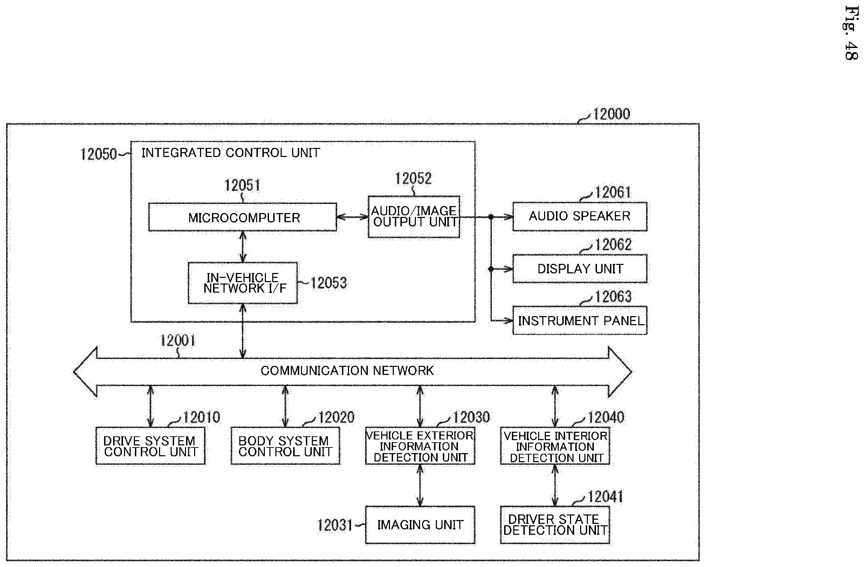

   Fig. 48 is a block diagram illustrating an example of an overall configuration of a vehicle control system.
[Fig. 49]

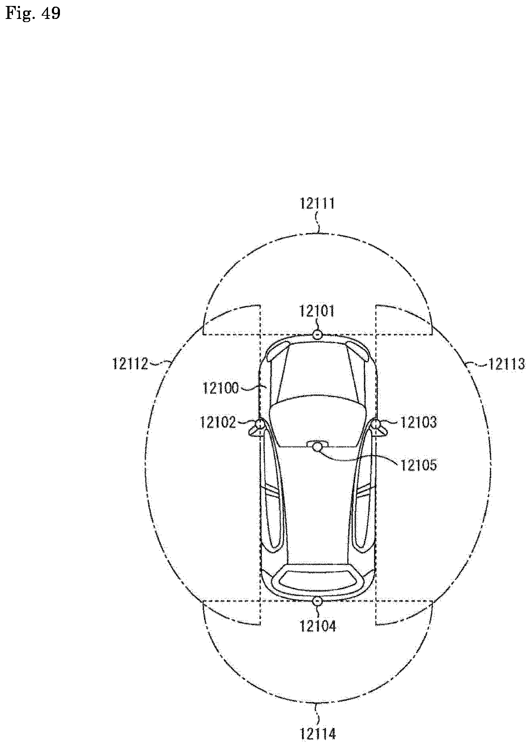

   Fig. 49 is an explanatory diagram illustrating an example of positions at which a vehicle exterior information detection unit and an imaging unit are installed.

### [Description of Embodiments]

Embodiments of a photoelectric conversion element and an imaging device will be described below with reference to the drawings. Although the main components of the photoelectric conversion element and the imaging device will be mainly described below, the photoelectric conversion element and the imaging device may include components and functions that are not illustrated or explained. The following description does not exclude components or functions that are not illustrated or described.

### (First Embodiment)

Fig. 1 is a cross-sectional view of a photoelectric conversion element 1 according to the first embodiment, and Fig. 2 is a plan view of the photoelectric conversion element 1 of Fig. 1 viewed from the light incidence surface side. Fig. 1 illustrates a cross-sectional structure taken along line A-A in Fig. 2.

Fig. 1 illustrates a cross-sectional structure of the photoelectric conversion element 1 for two pixels in the X direction, and Fig. 2 illustrates a plan view for two pixels in the X direction and the Y direction. In reality, a large number of pixels are arranged in the X direction and the Y direction. A pixel array unit is configured by arranging a plurality of photoelectric conversion elements 1 of Fig. 1 in a two-dimensional direction.

The photoelectric conversion element 1 illustrated in Fig. 1 is applied to, for example, an infrared sensor using a compound semiconductor material such as a group III-V semiconductor. The photoelectric conversion element 1 in Fig. 1 can perform photoelectric conversion on light having wavelengths from the visible region (380 nm or more and less than 780 nm) to the short infrared region (780 nm or more and less than 2400 nm), for example.

The lower surface of the photoelectric conversion element 1 in Fig. 1 is a light incidence surface f1. In this specification, the light incidence surface f1 of the photoelectric conversion element 1 may be referred to as a back surface f1, and the surface opposite to the light incidence surface f1 may be referred to as a front surface f2.

The photoelectric conversion element 1 in Fig. 1 includes a first semiconductor layer 2 of a first conductivity type, a second semiconductor layer 3 of the first conductivity type, a third semiconductor layer 4 of the first conductivity type, a first diffusion layer 5 of a second conductivity type, a first electrode 6, a second diffusion layer 7 of the second conductivity type, a second electrode 8, and an insulating layer 9. The first semiconductor layer 2, the second semiconductor layer 3, and the third semiconductor layer 4 constitute a photoelectric conversion layer. In this way, the second semiconductor layer 3 and the third semiconductor layer 4 are arranged on both sides of the first semiconductor layer 2.

The first semiconductor layer 2, the second semiconductor layer 3, and the third semiconductor layer 4 all contain a compound semiconductor material that performs photoelectric conversion. The second semiconductor layer 3 contains a compound semiconductor material having a larger band gap than the first semiconductor layer 2, and is stacked on the side of the first semiconductor layer 2 opposite to the light incidence surface. The third semiconductor layer 4 contains a compound semiconductor material having a larger band gap than the first semiconductor layer 2, and is stacked on the light incidence surface side of the first semiconductor layer 2.

As an example, the first semiconductor layer 2 is an n-type InGaAs layer, and the second semiconductor layer 3 and the third semiconductor layer 4 are n-type InP layers. Further, the first diffusion layer 5 and the second diffusion layer 7 are p+ diffusion layers. In this way, the photoelectric conversion element 1 in Fig. 1 has a stacked structure in which, for example, an InGaAs layer is sandwiched between two InP layers.

The first diffusion layer 5 is disposed to penetrate the second semiconductor layer 3 from the side of the second semiconductor layer 3 opposite to the light incidence surface and extend into the first semiconductor layer 2. For example, the first diffusion layer 5 is a p+ diffusion layer in which zinc (Zn) ions or the like are diffused. A pn junction is formed at the interface between the first diffusion layer 5 and the second semiconductor layer 3, but since the second semiconductor layer 3 has a large band gap, generation of dark current can be suppressed. Since the first diffusion layer 5 is disposed to penetrate the second semiconductor layer 3 and extend into the first semiconductor layer 2, the charges generated by photoelectric conversion inside the first semiconductor layer 2 can be collected by the first electrode 6 through the first diffusion layer 5.

The second diffusion layer 7 is arranged in the depth direction of the third semiconductor layer 4 from the light incidence surface side of the third semiconductor layer 4. More specifically, the second diffusion layer 7 is disposed to penetrate the third semiconductor layer 4 from the light incidence surface side of the third semiconductor layer 4 and extend into the first semiconductor layer 2. For example, the second diffusion layer 7 is a p+ diffusion layer in which zinc (Zn) ions or the like are diffused.

The first electrode 6 is in contact with the first diffusion layer 5 on the side of the second semiconductor layer 3 opposite to the light incidence surface. The second electrode 8 is in contact with the second diffusion layer 7 on the light incidence surface side of the third semiconductor layer 4. An insulating layer 9 is arranged between the second electrode 8 and the third semiconductor layer 4. By arranging the insulating layer 9 between the second electrode 8 and the third semiconductor layer 4, a short circuit between the second electrode 8 and the third semiconductor layer 4 can be prevented.

The first diffusion layer 5, first electrode 6, second diffusion layer 7, and second electrode 8 are provided for each pixel. The first to third semiconductor layers 2 to 4 are arranged across a plurality of pixel regions. Inside the first to third semiconductor layers 2 to 4, there is no structure (for example, a light shielding member) that separates the pixels. Therefore, photoelectric conversion can be performed in almost the entire area of the first to third semiconductor layers 2 to 4, and sensitivity can be improved.

A fourth semiconductor layer 10 of the first conductivity type is arranged on the light incidence surface side of the third semiconductor layer 4. The fourth semiconductor layer 10 has a higher impurity concentration than the third semiconductor layer 4, and is arranged electrically separated from the second electrode 8. For example, the fourth semiconductor layer 10 is an n+ InP layer. The fourth semiconductor layer 10 is arranged between the patterned insulating layers 9.

A transparent electrode layer 11 is arranged on the light incidence surface side of the fourth semiconductor layer 10. The surfaces of the second electrode 8, the insulating layer 9, and the transparent electrode layer 11 are covered with a protective film (passivation film) 12. An on-chip lens (not illustrated) may be arranged on the light incidence surface side of the protective film 12.

As illustrated in Fig. 2, the second electrode 8 is arranged approximately at the center of each pixel, and the insulating layer 9 is arranged around the second electrode 8. This insulating layer 9 is provided to prevent the second electrode 8 from contacting the third semiconductor layer 4. The potential of the third semiconductor layer 4 is set by the transparent electrode layer 11. The transparent electrode layer 11 is arranged around the second electrode 8 and the insulating layer 9, as illustrated in Fig. 2.

When the photoelectric conversion element 1 of Fig. 1 reads holes generated by photoelectric conversion, the voltage applied to the transparent electrode layer 11 is set higher than the voltage applied to the first electrode 6 and the second electrode 8. In this way, holes generated by photoelectric conversion inside the first semiconductor layer 2 are collected by the first electrode 6 and the second electrode 8 via the first diffusion layer 5 and the second diffusion layer 7.

The first semiconductor layer 2, the second semiconductor layer 3, the third semiconductor layer 4, the first diffusion layer 5, the first electrode 6, the second diffusion layer 7, the second electrode 8, the insulating layer 9, and the like are arranged on the first substrate 13. The charges collected by the first electrode 6 are transferred to the first readout circuit 15 in the second substrate 14 whereby a pixel signal is generated. Although not illustrated in Fig. 1, the charges collected by the second electrode 8 are also transferred to the second substrate 14 side by some means, and a pixel signal is generated in the second substrate 14.

The first substrate 13 and the second substrate 14 are bonded by Cu-Cu bonding, vias, bumps, and the like, and transmit and receive various signals. The first electrode 6 in the first substrate 13 is covered with an insulating film 36. A wiring layer 16 that is electrically connected to the first electrode 6 is formed in a portion of the insulating film 36, and the charges collected by the first electrode 6 are transferred to the first readout circuit 15 in the second substrate 14 via the wiring layer 16 and the Cu-Cu bonding 17.

In the photoelectric conversion element 1 of Fig. 1, both the first diffusion layer 5 and the second diffusion layer 7 are arranged even inside the first semiconductor layer 2. Therefore, charges generated by photoelectric conversion inside the first semiconductor layer 2 are attracted to either the first diffusion layer 5 or the second diffusion layer 7 and are collected by the first electrode 6 or the second electrode 8. More specifically, charges generated by photoelectric conversion inside the first semiconductor layer 2 are attracted to the closer one of the first diffusion layer 5 and the second diffusion layer 7. The charges attracted to the first diffusion layer 5 are collected by the first electrode 6. Further, the charges attracted to the second diffusion layer 7 are collected by the second electrode 8.

Charges generated by photoelectric conversion inside the first semiconductor layer 2 are electrons and holes. Either electrons or holes are collected by the first electrode 6 or the second electrode 8 via the first diffusion layer 5 or the second diffusion layer 7. In the example of Fig. 1, holes are collected by the first electrode 6 and the second electrode 8, and electrons are discharged. As described above, by making the voltage applied to the transparent electrode layer 11 higher than the voltage applied to the first electrode 6 and the second electrode 8, holes can be collected by the first electrode 6 and the second electrode 8.

In the photoelectric conversion element 1 of Fig. 1, both the first diffusion layer 5 and the second diffusion layer 7 are arranged even inside the first semiconductor layer 2. Therefore, the charges collected by the first electrode 6 and the second electrode 8 via the first diffusion layer 5 and the second diffusion layer 7 are charges that have been photoelectrically converted in the first semiconductor layer 2. Therefore, the first electrode 6 and the second electrode 8 detect light in the same wavelength band.

In the case of a photoelectric conversion layer made of a compound semiconductor material like the first to third semiconductor layers 2 to 4, it is difficult in terms of process to form a light shielding wall at the boundary between pixels. Further, when a light shielding wall is provided, dark current is likely to be generated near the surface of the light shielding wall, and the noise components included in the pixel signal increase. In the photoelectric conversion element 1 according to the present embodiment, the first semiconductor layer 2 is sandwiched between the second semiconductor layer 3 and the third semiconductor layer 4, which have a larger band gap than the first semiconductor layer 2, and the first diffusion layer 5 and the second diffusion layer 7 that reach the first semiconductor layer 2 are provided in the second semiconductor layer 3 and the third semiconductor layer 4. In this way, charges generated by photoelectric conversion inside the first semiconductor layer 2 can be drawn to the closer one of the first diffusion layer 5 and the second diffusion layer 7. Therefore, according to the present embodiment, the charges generated by photoelectric conversion inside the first semiconductor layer 2 can be efficiently collected by the first electrode 6 and the second electrode 8, and there is no fear that the charges will enter adjacent pixels. Thus, crosstalk can be suppressed.

Furthermore, in the photoelectric conversion element 1 according to the present embodiment, there is no structure such as a light shielding member that separates pixels inside the first to third semiconductor layers 2 to 4. Thus, it is possible to increase the area where photoelectric conversion is possible and improve the sensitivity. Furthermore, by not providing a light shielding member, generation of dark current can also be suppressed.

In the photoelectric conversion element 1 of Fig. 1, the first to third semiconductor layers 2 to 4 are n-type, and the first diffusion layer 5 and second diffusion layer 7 are p-type, but the conductivity types may be reversed. Furthermore, although Fig. 1 illustrates an example in which holes generated by photoelectric conversion are read out, electrons may also be read out. When reading out electrons, the voltage applied to the first electrode 6 and the second electrode 8 may be higher than the voltage applied to the transparent electrode layer 11.

In this way, in the photoelectric conversion element 1 according to the first embodiment, the first diffusion layer 5 and the second diffusion layer 7 are arranged on both sides of the first semiconductor layer 2. Therefore, the charges generated by the photoelectric conversion inside the first semiconductor layer 2 can be drawn to the closer one of the first diffusion layer 5 and the second diffusion layer 7, and the entrance of charges into adjacent pixels can be suppressed. Furthermore, in the photoelectric conversion element 1 according to the first embodiment, since there is no structure inside the first to third semiconductor layers 2 to 4 that separates pixels, the sensitivity can be improved.

### (Second Embodiment)

In the photoelectric conversion element 1 of Fig. 1, an example is illustrated in which the charges collected by the first electrode 6 are read out on the front surface f2 side, and the charges collected by the second electrode 8 are read out on the back surface f1 side. In contrast, in the photoelectric conversion element 1 according to the second embodiment, the charges collected by the first electrode 6 and the second electrode 8 are both read out on the front surface f2 side.

Fig. 3 is a cross-sectional view of a photoelectric conversion element 1a according to the second embodiment. A plan view of the photoelectric conversion element 1a according to the second embodiment viewed from the light incidence surface side is similar to Fig. 2. The cross-sectional view in Fig. 3 illustrates the cross-sectional structure taken along the line A-A in Fig. 2.

In Fig. 3, the same components as those in Fig. 1 are denoted by the same reference numerals, and the following description will focus on the differences. The photoelectric conversion element 1a in Fig. 3 has a via 18 connected to the second electrode 8. This via 18 is arranged in the depth direction from the light incidence surface side of the first substrate 13, and the end portion of the via 18 on the front surface f2 side is connected to a second readout circuit 19 in the second substrate 14 by the Cu-Cu bonding 17. The second readout circuit 19 generates a pixel signal according to the charges transferred from the second electrode 8 via the via 18.

The via 18 is formed by placing an insulating film 21 in a trench 20 formed in the first substrate 13 and placing a conductive film 22 thereon. The inside of the conductive film 22 may be filled with some kind of material. The diameter and width of the via 18 are arbitrary. However, when the diameter and width of the via 18 are increased, the area for photoelectric conversion in the first to third semiconductor layers 2 to 4 becomes narrower, and there is a risk that sensitivity decreases and dark current increases. Therefore, it is desirable that the diameter and width of the via 18 be set to such an extent that a decrease in sensitivity will not be a problem.

Further, one or more vias 18 are provided for each pixel, but as the number of vias 18 increases, the area for photoelectric conversion becomes narrower, which may lead to a decrease in sensitivity and an increase in dark current. Therefore, it is desirable to provide the minimum number of vias 18 required.

Fig. 4 is a cross-sectional view taken along line B-B in Fig. 2. As can be seen from Fig. 4, the diameter of the via 18 is made narrower than the widths of the first diffusion layer 5 and the second diffusion layer 7. Therefore, there is no possibility that the via 18 will interfere with photoelectric conversion, and a decrease in sensitivity can be suppressed. Note that Fig. 4 is an example, and the diameter of the via 18 may be made larger than the width of the first diffusion layer 5 and the second diffusion layer 7 if the decrease in sensitivity is not a big problem.

In this way, in the photoelectric conversion element 1a according to the second embodiment, the charges collected by the second electrode 8 are transferred to the second readout circuit 19 in the second substrate 14 via the via 18 extending in the depth direction of the first substrate 13. Therefore, the charges collected by the first electrode 6 and the second electrode 8 can be transferred to the first readout circuit 15 and the second readout circuit 19 in the second substrate 14 whereby a pixel signal can be generated. The vias 18 extending in the depth direction of the first substrate 13 have a size that does not prevent the first semiconductor layer 2 from performing photoelectric conversion, so there is no risk of deterioration in sensitivity. Further, as in the first embodiment, the charges generated by photoelectric conversion inside the first semiconductor layer 2 are attracted to the first diffusion layer 5 or the second diffusion layer 7. Therefore, it is possible to prevent charges from entering adjacent pixels and suppress crosstalk.

### (Third Embodiment)

In the first and second embodiments, an example is illustrated in which one second diffusion layer 7 and one second electrode 8 are provided for each pixel, but it is also possible to provide a plurality of second diffusion layers 7 and a plurality of second electrodes 8 for each pixel.

Fig. 5 is a cross-sectional view of a photoelectric conversion element 1b according to the third embodiment, and Fig. 6 is a plan view seen from the light incidence surface side of Fig. 5. Figs. 5 and 6 illustrate an example in which four second diffusion layers 7 and four second electrodes 8 are provided for each pixel. As illustrated in Fig. 6, the four second electrodes 8 provided for each pixel are electrically connected by a wiring layer 23. Furthermore, one or more vias 18 are provided for each pixel, and the vias 18 are electrically connected to the four second electrodes 8. The via 18 is arranged in the depth direction from the light incidence surface side of the first substrate 13 and is electrically connected to the second readout circuit 19 in the second substrate 14 via, for example, a Cu-Cu bonding 17. Therefore, the charges collected by the four second electrodes 8 provided for each pixel are transferred to the second readout circuit 19 via the vias 18.

The photoelectric conversion element 1b in Fig. 5 has a plurality of second diffusion layers 7 and a plurality of second electrodes 8 for each pixel. Therefore, charges generated by photoelectric conversion inside the first photoelectric conversion unit can be efficiently collected by the plurality of second diffusion layers 7, and quantum efficiency can be improved. In particular, in the present embodiment, the plurality of second electrodes 8 in the pixel are electrically connected through the wiring layer 23 and connected to the second readout circuit 19 in the second substrate 14 via the via 18. The charges collected by the four second diffusion layers 7 can be efficiently transferred to the second readout circuit 19 via the via 18.

As illustrated in Fig. 6, since the plurality of second electrodes 8 in the pixel are arranged at the four corners of the pixel, the aperture ratio of the pixel can be secured, and even if a plurality of second electrodes 8 are provided, there is no fear that the sensitivity will decrease.

In Fig. 6, an example is illustrated in which one first diffusion layer 5 and one first electrode 6 are provided for each pixel, and four second diffusion layers 7 and four second electrodes 8 are provided for each pixel. However, m (m is an integer of 1 or more) first diffusion layers 5 and m first electrodes 6 may be provided for each pixel. Further, n (n is an integer of 1 or more) second diffusion layers 7 and n second electrodes 8 may be provided for each pixel. Alternatively, the first diffusion layer 5 and the first electrode 6 may be provided for every m (m is an integer of 1 or more) pixels. In either case, the first to third semiconductor layers 2 to 4 are arranged across a plurality of pixels.

### (Fourth Embodiment)

Fig. 7 is a cross-sectional view of a photoelectric conversion element 1c according to the fourth embodiment. The amount of charges (for example, holes) collected by the first electrode 6 depends on the potential difference between the voltage VDD applied to the transparent electrode layer 11 and the voltage V1 applied to the first electrode 6. Similarly, the amount of charges (for example, holes) collected by the second electrode 8 depends on the potential difference between the voltage VDD applied to the transparent electrode layer 11 and the voltage V2 applied to the second electrode 8.

The first readout circuit 15 generates a pixel signal according to the charges collected by the first electrode 6, and the second readout circuit 19 generates a pixel signal according to the charges collected by the second electrode 8.

The first electrode 6 and the first readout circuit 15 are electrically connected, and the voltage of the first electrode 6 can be controlled by the voltage V1 applied to the first readout circuit 15. Similarly, the second electrode 8 and the second readout circuit 19 are electrically connected, and the voltage of the second electrode 8 can be controlled by the voltage V2 applied to the second readout circuit 19.

In Fig. 7, the first readout circuit 15 can arbitrarily control the voltage of the first electrode 6, and the second readout circuit 19 can arbitrarily control the voltage of the second electrode 8. In this way, the first readout circuit 15 can control the amount of charges collected by the first electrode 6, and the second readout circuit 19 can control the amount of charges collected by the second electrode 8. Therefore, according to the present embodiment, the voltage applied to the first electrode 6 and the second electrode 8 can be controlled according to the electrical characteristics of the first readout circuit 15 and the second readout circuit 19, and the degree of freedom in design of the photoelectric conversion element 1c can be expanded.

### (Fifth Embodiment)

In Figs. 3 to 7, an example has been illustrated in which the via 18 extending in the depth direction from the light incidence surface side of the first substrate 13 is electrically connected to the second readout circuit 19 in the second substrate 14 by the Cu-Cu bonding 17 or the like. However, a via 18 that penetrates the first substrate 13 and reaches the second readout circuit 19 in the second substrate 14 may be provided.

Fig. 8 is a cross-sectional view of a photoelectric conversion element 1d according to the fifth embodiment. A plan view of the photoelectric conversion element 1d according to the fifth embodiment when viewed from the light incidence surface side is the same as that in Fig. 2, and Fig. 8 illustrates a cross-sectional structure taken along the line A-A in Fig. 2. Fig. 9 is a cross-sectional view taken along line B-B in Fig. 2.

In the photoelectric conversion element 1d in Fig. 8, the shape of the via 18 is different from that in Figs. 3 to 7. The via 18 in the photoelectric conversion element 1d in Fig. 8 penetrates the first substrate 13 from the light incidence surface side of the first substrate 13 and reaches the second readout circuit 19 in the second substrate 14.

This eliminates the need for alignment between the end of the via 18 and the Cu-Cu bonding 17, thereby simplifying the manufacturing process.

Further, as illustrated in Fig. 9, the diameter of the via 18 is narrower than the width of the first diffusion portion and the second diffusion portion, so even if the via 18 is provided, there is no risk of deterioration in sensitivity.

### (Sixth Embodiment)

In the first to fifth embodiments, an example has been described in which the first diffusion layer 5, the first electrode 6, the second diffusion layer 7, the second electrode 8, and the via 18 are provided for each pixel. However, the first diffusion layer 5, the first electrode 6, the second diffusion layer 7, the second electrode 8, and the via 18 may be shared by a plurality of pixels. For example, one first diffusion layer 5, one first electrode 6, one second diffusion layer 7, one second electrode 8, and one via 18 may be provided for all pixels in the pixel array unit. Alternatively, the first diffusion layer 5, first electrode 6, second diffusion layer 7, second electrode 8, and via 18 may be provided for every plurality of pixels.

Fig. 10 is a cross-sectional view of a photoelectric conversion element 1e according to the sixth embodiment, and Fig. 11 is a plan view of the photoelectric conversion element 1e of Fig. 10 as viewed from the light incidence surface side. Fig. 10 illustrates an example in which two vias 18 (hereinafter referred to as a first via 18a and a second via 18b) are shared by a plurality of pixels in a pixel array unit. In the following, an example will be described in which the first via 18a and the second via 18b are shared by all pixels in the pixel array unit.

In the photoelectric conversion element 1e of Fig. 10, the first electrode 6 collects charges generated by photoelectric conversion inside the first semiconductor layer 2 via the first diffusion layer 5, and transfers them to the first readout circuit 15 in the second substrate 14 to generate a pixel signal. On the other hand, it is assumed that the charges collected by the second electrode 8 are discharged.

That is, the first via 18a and the second via 18b in Fig. 10 are used not for reading out the charges generated by photoelectric conversion but for discharging the charges. The first via 18a is electrically connected to the transparent electrode layer 11 on the light incidence surface side. When a voltage higher than that applied to the first electrode 6 and the second electrode 8 is applied to the transparent electrode layer 11, the transparent electrode layer 11 can collect electrons generated by photoelectric conversion. The electrons collected by the transparent electrode layer 11 are discharged to the second substrate 14 side via the first via 18a. The second via 18b is electrically connected to the second electrode 8. The second electrode 8 collects holes generated by photoelectric conversion. The holes collected by the second electrode 8 are transferred to the second substrate 14 side via the second via 18b. By transferring holes through the second via 18b, it is possible to reduce holes flowing into adjacent pixels and reduce crosstalk.

As illustrated in Fig. 11, the plurality of second electrodes 8 are connected by the wiring layer 23, and this wiring layer 23 is connected to the second via 18b. Although Fig. 11 illustrates an example in which the first via 18a and the second via 18b extend not only in the depth direction of the first substrate 13 but also in the X direction, the first via 18a and the second via 18b may be narrow in the X direction. In this way, the first via 18a and the second via 18b do not interfere with photoelectric conversion of the first to third semiconductor layers 2 to 4, and a decrease in sensitivity can be suppressed.

### (Seventh Embodiment)

Next, the manufacturing process of the photoelectric conversion element 1 according to the first to sixth embodiments will be explained. The order of manufacturing steps of the photoelectric conversion element 1 according to the first to sixth embodiments is almost the same. Hereinafter, the manufacturing process of the photoelectric conversion element 1 of the second embodiment (Fig. 3) will be described.

Figs. 12A to 12I are process diagrams illustrating the manufacturing process of the photoelectric conversion element 1 of Fig. 3. First, on an n-type InP substrate 100, an n-type InGaAs layer corresponding to the first semiconductor layer 2, an n-type InP layer corresponding to the second semiconductor layer 3, an n-type InP layer corresponding to the third semiconductor layer 4, and an n+ InP layer corresponding to the fourth semiconductor layer 10 are sequentially formed by epitaxial growth. In Figs. 12A to 12I, the first to fourth semiconductor layers 2 to 4, and 10 are collectively referred to as a semiconductor layer 30. After that, an adhesive layer 31 is formed on the semiconductor layer 30 (more specifically, the second semiconductor layer 3). The adhesive layer 31 is an insulating material made of TEOS (tetraethoxysilane) or the like.

Next, as illustrated in Fig. 12B, the semiconductor layer 30 manufactured in Fig. 12A is bonded to a support substrate 32 made of silicon via the adhesive layer 31. In this way, the semiconductor layer 30 is attached to the support substrate 32 with the adhesive layer 31. Fig. 12B illustrates an example in which a plurality of semiconductor layers 30 are bonded onto the support substrate 32.

Next, as illustrated in Fig. 12C, after removing the InP substrate, the surfaces of the plurality of semiconductor layers 30 on the support substrate 32 are covered with an insulating film 33 for a hard mask. This insulating film 33 is also formed of an insulating material such as TEOS. Subsequently, a portion of the insulating film 33 is removed by photolithography or the like, and a layer corresponding to the fourth semiconductor layer 10 is removed from the portion of the semiconductor layer 30 from which the insulating film 33 has been removed. Thereafter, zinc (Zn) ions are implanted from the top surface to form a P+ diffusion layer corresponding to the second diffusion layer 7.

Next, as illustrated in Fig. 12D, the surface of the insulating film 33 is covered with a buried insulating film 34. The buried insulating film 34 is an inorganic insulating material such as silicon oxide (SiOx), silicon nitride (SiN), silicon oxynitride (SiON), carbon-containing silicon oxide (SiOC), and silicon carbide (SiC). An adhesive layer 35 is arranged on the buried insulating film 34. This adhesive layer 35 is an insulating material such as TEOS.

Next, as illustrated in Fig. 12E, the support substrate 37 is attached to the surface opposite to the support substrate 32 (light incidence surface) using the adhesive layer 35. Next, as illustrated in Fig. 12F, the support substrate 32 and the adhesive layer 31 are peeled off, an insulating film 38 is formed on the peeled surface, and then the insulating film 38 is partially removed by lithography, and Zinc (Zn) ions are implanted into the n-type InP layer corresponding to the second semiconductor layer 3 to form a P+ diffusion layer corresponding to the first diffusion layer 5.

Next, as illustrated in Fig. 12G, the first electrode 6 is formed on the P+ diffusion layer corresponding to the first diffusion layer 5, and the insulating film 36 is placed thereon. Next, a portion of the insulating film 36 is removed by lithography or the like to form a wiring layer 39 electrically connected to the first electrode 6. The first electrode 6 and the wiring layer 39 are made of a conductive material such as copper (Cu) or tungsten (W).

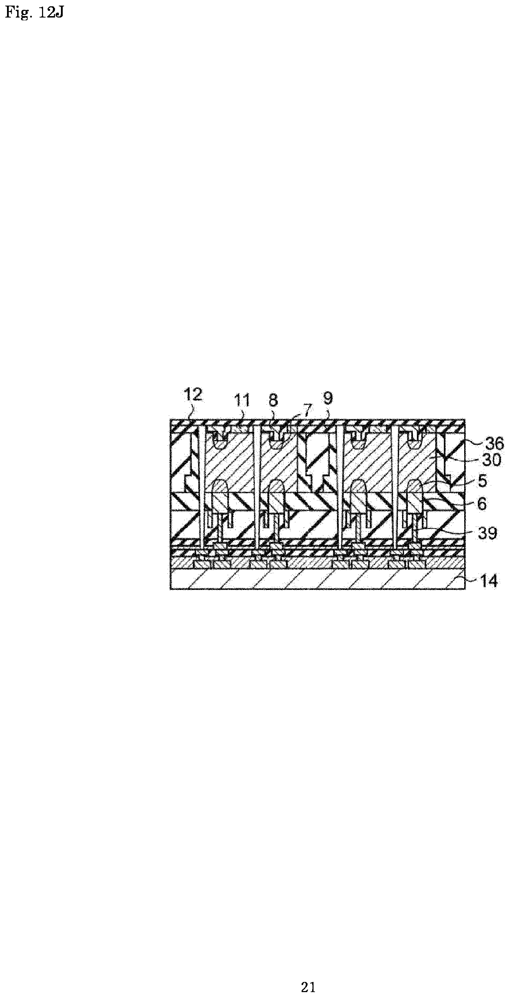

Next, as illustrated in Fig. 12H, the second substrate 14 on which the first readout circuit 15 and the second readout circuit 19 are formed is bonded to the surface on which the wiring layer 39 is formed by a Cu-Cu bonding 17. Next, as illustrated in Fig. 12I, after the support substrate 37 and the insulating film 36 are removed to form the insulating layer 9, a portion of the insulating layer 9 is removed to form the second electrode 8. Thereafter, as illustrated in Fig. 12J, a transparent electrode layer 11 is formed on the fourth semiconductor layer 10. Thereafter, a trench 20 is formed in the depth direction from the light incidence surface (back surface f1) side. An insulating film 21 and a conductive film 22 are sequentially formed inside the trench 20 to form a via 18. Thereafter, a protective film 12 is formed over the entire back surface f1 (light incidence surface) side. Thereafter, an on-chip lens may be formed on the back surface f1 side.

In this way, the photoelectric conversion elements 1 to 1e according to the first to sixth embodiments can be formed by a general-purpose semiconductor process, and the yield can be improved.

### (Eighth Embodiment)

In the first to sixth embodiments described above, the second diffusion layer 7 penetrates the third semiconductor layer 4 and extends into the first semiconductor layer 2. However, by keeping the second diffusion layer 7 inside the third semiconductor layer 4, the first electrode 6 and the second electrode 8 can detect light in different wavelength bands.

Fig. 13 is a cross-sectional view of a photoelectric conversion element 1f according to the eighth embodiment, and Fig. 14 is a plan view of the photoelectric conversion element 1f of Fig. 13 viewed from the light incidence surface side. In Figs. 13 and 14, the same components as those in Figs. 1 to 11 are denoted by the same reference numerals, and the following description will focus on the differences.

The plan view of Fig. 14 is substantially the same as the plan view of Fig. 2. As can be seen by comparing the cross-sectional structure of Fig. 13 with the cross-sectional structure of Fig. 3, in the photoelectric conversion element 1f of Fig. 13, the second diffusion layer 7 made of a p+ diffusion layer remains inside the third semiconductor layer 4 made of an n-type InP layer. On the other hand, in the photoelectric conversion element 1a of Fig. 3, the second diffusion layer 7 penetrates the third semiconductor layer 4 and reaches the inside of the first semiconductor layer 2 made of an n-type InGaAs layer. Other structures are common between Figs. 3 and 13.

Since the third semiconductor layer 4 has a larger band gap than the first semiconductor layer 2, the third semiconductor layer 4 does not absorb infrared light, but only absorbs light in the visible light band, and can perform photoelectric conversion. Therefore, among the light components incident from the light incidence surface, light in the visible light band is absorbed by the third semiconductor layer 4, and charges generated by photoelectric conversion inside the third semiconductor layer 4 are collected by the second electrode 8. On the other hand, among the light components incident from the light incidence surface, most of the light in the infrared band is transmitted through the third semiconductor layer 4 and absorbed by the first semiconductor layer 2, and the charges generated by the photoelectric conversion inside the first semiconductor layer 2 are collected by the first electrode 6.

In this way, the first electrode 6 is used to read out the charges generated by photoelectric conversion of infrared light, and the second electrode 8 is used to read out the charges generated by photoelectric conversion of visible light. In the photoelectric conversion elements 1 to 1e according to the first to sixth embodiments described above, both the first diffusion layer 5 and the second diffusion layer 7 are arranged inside the first semiconductor layer 2. Therefore, the first electrode 6 and the second electrode 8 are used to read out charges generated by photoelectric conversion of light in the same wavelength band (mainly infrared light band), and it is not possible to read out light in different wavelength bands separately. This point is a major difference between the photoelectric conversion element 1f according to the eighth embodiment and the photoelectric conversion elements 1 to 1e according to the first to sixth embodiments.

In the photoelectric conversion element 1f in Fig. 13, the charges (for example, holes) collected by the first electrode 6 are transferred to the first readout circuit 15 in the second substrate 14 via the Cu-Cu bonding 17, and a pixel signal corresponding to light in the infrared light band is generated. Further, the charges (for example, holes) collected by the second electrode 8 are transferred to the second readout circuit 19 in the second substrate 14 via the vias 18 and the Cu-Cu bonding 17, and a pixel signal corresponding to the light in the visible light band is generated.

The via 18 only needs to be formed at a portion of the pixel boundary. Fig. 15 is a cross-sectional view taken along line B-B in Fig. 14. As illustrated in Fig. 15, the diameter (width) of the via 18 is narrower than the widths of the first diffusion layer 5 and the second diffusion layer 7. Further, one or more vias 18 are provided in each pixel, but by reducing the diameter of the vias 18 and reducing the number of vias 18, a decrease in sensitivity can be suppressed.

In this manner, in the photoelectric conversion element 1f according to the eighth embodiment, charges generated by photoelectric conversion of infrared light and charges generated by photoelectric conversion of visible light can be read out separately. In addition, the first diffusion layer 5 is arranged inside the first semiconductor layer 2 and the second diffusion layer 7 is arranged inside the third semiconductor layer 4 for each pixel. Therefore, the charges generated by photoelectric conversion inside the first semiconductor layer 2 s or the third semiconductor layer 4 in each pixel can be collected by the first electrode 6 or the second electrode 8 without leaking through the first diffusion layer 5 or the second diffusion layer 7, and so-called crosstalk, in which charges leak out to adjacent pixels, can be suppressed.

Furthermore, since there is no light shielding member or the like inside the first to third semiconductor layers 2 to 4, dark current can be suppressed, and since the volume of the photoelectric conversion region can be expanded, a decrease in sensitivity can be suppressed.

### (Ninth Embodiment)

Fig. 16 is a cross-sectional view of a photoelectric conversion element 1g according to the ninth embodiment, and Fig. 17 is a plan view of the photoelectric conversion element 1g of Fig. 16 viewed from the light incidence surface side. In Figs. 16 and 17, the same components as those in Figs. 5 and 6 are denoted by the same reference numerals, and the following description will focus on the differences.

The plan view of Fig. 17 is substantially the same as the plan view of Fig. 6. In the photoelectric conversion element 1g of Fig. 16, the second diffusion layer 7 remains inside the third semiconductor layer 4, unlike the photoelectric conversion element 1b of Fig. 5. Other structures are common between Figs. 16 and 5. Therefore, in the photoelectric conversion element 1g of Fig. 16, the first electrode 6 collects charges generated by photoelectric conversion of infrared light, and the second electrode 8 collects charges generated by photoelectric conversion of visible light.

In addition, the photoelectric conversion element 1g in Fig. 16 has a plurality of second electrodes 8 for each pixel and a wiring layer 23 that electrically connects these second electrodes 8, so that charges generated by photoelectric conversion of visible light can be collected by these second electrodes 8 without leaking, and the sensitivity of visible light can be improved.

### (Tenth Embodiment)

Fig. 18 is a cross-sectional view of a photoelectric conversion element 1h according to the tenth embodiment. In Fig. 18, the same components as those in Fig. 7 are denoted by the same reference numerals, and the following description will focus on the differences.

In the photoelectric conversion element 1h of Fig. 18, the second diffusion layer 7 remains inside the third semiconductor layer 4, unlike the photoelectric conversion element 1c of Fig. 7. Other structures are common between Figs. 18 and 7.

In the photoelectric conversion element 1h of Fig. 18, the potential difference between the transparent electrode layer 11 and the first diffusion layer 5 and the potential difference between the transparent electrode layer 11 and the second diffusion layer 7 can be individually controlled, and the signal levels of the pixel signal generated by the first readout circuit 15 and the pixel signal generated by the second readout circuit 19 can be optimized, and the S/N ratio can be improved.

### (Eleventh Embodiment)

Fig. 19 is a cross-sectional view of the photoelectric conversion element 1 according to the eleventh embodiment. In Fig. 19, the same components as those in Fig. 8 are denoted by the same reference numerals, and the following description will focus on the differences.

In the photoelectric conversion element 1i of Fig. 19, the second diffusion layer 7 remains inside the third semiconductor layer 4, unlike the photoelectric conversion element 1d of Fig. 8. Other structures are common between Figs. 19 and 8.

A plan view of the photoelectric conversion element 1i in Fig. 19 viewed from the light incidence surface side is the same as Fig. 14. Fig. 20 is a cross-sectional view taken along line B-B in Fig. 14. Similar to the photoelectric conversion element 1d in Fig. 8, the photoelectric conversion element 1i in Fig. 19 has a via 18 that penetrates the first substrate 13 from the light incident surface side of the first substrate 13 and reaches the second readout circuit 19 in the second substrate 14. As illustrated in Fig. 20, this via 18 is provided only in a portion of the pixel. Therefore, a decrease in sensitivity can be suppressed. In addition, by forming the via 18 that penetrates the first substrate 13 from the light incidence surface side of the first substrate 13 and reaches the second readout circuit 19 in the second substrate 14, there is no need to align the vias 18 and the Cu-Cu bonding 17, making manufacturing easier.

### (Twelfth Embodiment)

In the photoelectric conversion elements 1f to 1i according to the eighth to eleventh embodiments, the first electrode 6 and the second electrode 8 can read out the charges corresponding to light in the infrared light band and the charges corresponding to light in the visible light band separately. However, in order to further improve the sensitivity, it is necessary that the first semiconductor layer 2 is set to a thickness suitable for photoelectric conversion of light in the infrared light band, and the third semiconductor layer 4 is set to a thickness suitable for photoelectric conversion of light in the visible light band.

Fig. 21 is a cross-sectional view of a photoelectric conversion element 1j according to the twelfth embodiment. The first semiconductor layer 2 in the photoelectric conversion element 1j of Fig. 21 is set to a thickness suitable for photoelectric conversion of light in the infrared light band included in the light incident from the light incidence surface. Similarly, the third semiconductor layer 4 is set to a thickness suitable for photoelectric conversion of light in the visible light band included in light incident from the light incidence surface. In this way, it is possible to increase the charges generated by photoelectric conversion in the infrared light band collected by the first electrode 6 and the charges generated by photoelectric conversion in the visible light band collected by the second electrode 8 and improve the sensitivity.

### (Thirteenth Embodiment)

The number of pixels that perform photoelectric conversion of visible light and the number of pixels that perform photoelectric conversion of infrared light do not necessarily need to be the same, and may be different.

Fig. 22 is a cross-sectional view of a photoelectric conversion element 1k according to the thirteenth embodiment, and Fig. 23 is a plan view of the photoelectric conversion element 1k of Fig. 22 viewed from the light incidence surface side. As illustrated in Figs. 22 and 23, one first electrode 6 that collects charges generated by photoelectric conversion of infrared light is provided with respect to four second electrodes 8 that collect charges generated by photoelectric conversion of visible light. That is, one pixel that performs photoelectric conversion of infrared light is provided for four pixels that perform photoelectric conversion of visible light. This allows visible light to be detected with higher resolution than infrared light.

Fig. 24 is a cross-sectional view of a photoelectric conversion element 1m according to a modified example of Fig. 22, and Fig. 25 is a plan view of the photoelectric conversion element 1m of Fig. 24 as viewed from the light incidence surface side. As illustrated in Figs. 24 and 25, four first electrode 6 that collects charges generated by photoelectric conversion of infrared light are provided with respect to one second electrode 8 that collects charges generated by photoelectric conversion of visible light. That is, four pixels that perform photoelectric conversion of infrared light are provided for one pixel that performs photoelectric conversion of visible light. This allows infrared light to be detected with higher resolution than visible light.

The photoelectric conversion elements 1f to 1m according to the eighth to twelfth embodiments described above are different from the photoelectric conversion elements 1 to 1e according to the first to sixth embodiments in that the second diffusion layer 7 remains inside the third semiconductor layer 4, and the other structures are common. Therefore, the photoelectric conversion elements 1f to 1m according to the eighth to twelfth embodiments can also be manufactured by the manufacturing process illustrated in Figs. 12A to 12I.

### (Fourteenth Embodiment)

In the photoelectric conversion elements 1f to 1m illustrated in Figs. 13 to 25, it is assumed that the second diffusion layer 7 remains inside the third semiconductor layer 4, and the second diffusion layer 7 collects all the holes photoelectrically converted by the third semiconductor layer 4. However, since the first semiconductor layer 2 and the third semiconductor layer 4 are in contact with each other, some of the holes photoelectrically converted in the third semiconductor layer 4 move to the first semiconductor layer 2 and are collected by the first diffusion layer 5, making it impossible to read out visible light and infrared light separately. Therefore, the photoelectric conversion element 1n according to the fourteenth embodiment described below is intended to eliminate such a problem.

Fig. 26 is a cross-sectional view of a photoelectric conversion element 1n according to the fourteenth embodiment, and Fig. 27 is a plan view of the photoelectric conversion element 1n of Fig. 26 viewed from the light incidence surface side. In Figs. 26 and 27, the same components as those in Figs. 1 to 25 are denoted by the same reference numerals, and the following description will focus on the differences.

The photoelectric conversion element 1n in Fig. 26 includes a barrier layer 51 disposed between the first semiconductor layer 2 and the third semiconductor layer 4. The barrier layer 51 is a layer that prevents charges generated by photoelectric conversion in the third semiconductor layer 4 from entering the first semiconductor layer 2. The barrier layer 51 contains a material with a larger band gap than third semiconductor layer 4. By making the bandgap of the barrier layer 51 larger than the bandgap of the third semiconductor layer 4, the charges generated by photoelectric conversion in the third semiconductor layer 4 will be blocked by the potential barrier of the barrier layer 51, and will not be able to move to the first semiconductor layer 2.

In addition, the photoelectric conversion element 1n in Fig. 26 includes a third via 52 that penetrates the third semiconductor layer 4 and extends to the barrier layer 51. In the photoelectric conversion element 1a of Fig. 3, electrons generated by photoelectric conversion in the first semiconductor layer 2 are discharged to the light incidence surface side. However, in the photoelectric conversion element 1n of Fig. 26, the barrier layer 51 is disposed between the first semiconductor layer 2 and the third semiconductor layers 4. Therefore, in this state, the electrons generated by photoelectric conversion in the first semiconductor layer 2 cannot be discharged to the light incidence surface side.

Therefore, in the photoelectric conversion element 1n of Fig. 26, electrons generated by photoelectric conversion in the first semiconductor layer 2 are transferred to the transparent electrode layer 11 on the light incidence surface side via the third via 52 and discharged.

More specifically, a fourth via 53 for discharging electrons is provided near the third via 52. This fourth via 53 is arranged, for example, in the pixel boundary region, and is arranged in the depth direction to penetrate the first substrate 13 and reach the readout circuit inside the second substrate 14. Electrons generated by photoelectric conversion in the first semiconductor layer 2 are transferred to the transparent electrode layer 11 via the third via 52 and discharged from the transparent electrode layer 11 via the fourth via 53 to the second substrate 14.

Further, the photoelectric conversion element 1n according to the fourteenth embodiment includes a second via 18b that discharges the electrons generated by photoelectric conversion in the second semiconductor layer 4 to the readout circuit side via the transparent electrode layer 11. The second via 18b is arranged, for example, in the pixel boundary region or outside the pixel region.

To summarize the above, as illustrated in Fig. 27, the photoelectric conversion element 1n according to the fourteenth embodiment has, for each pixel, the first via 18 that transfers holes to the readout circuit side, the third via 52 that transfers the electrons from the first semiconductor layer 2 to the transparent electrode layer 11, the fourth via 53 that discharges the electrons transferred to the transparent electrode layer 11 to the second substrate 14 side, and the second via 18b that discharges the electrons generated by photoelectric conversion in the second semiconductor layer 4 to the readout circuit side.

A plurality of candidates can be used for the material of the barrier layer 51. Fig. 28 is a cross-sectional view illustrating a first specific example of the photoelectric conversion element 1n according to the fourteenth embodiment, and Fig. 29 is a potential diagram of the photoelectric conversion element 1n of Fig. 28. Fig. 28 illustrates a cross-sectional structure around the barrier layer 51, and the third via 52, fourth via 53, and second via 18b are omitted.

Fig. 28 illustrates an example in which the material of the barrier layer 51 is N⁺-GaP or N⁺-GaAsSb. As illustrated in Fig. 29, N⁺-GaP or N⁺-GaAsSb has a larger band gap than N-InP, which is the material of the third semiconductor layer 4. Therefore, holes generated by photoelectric conversion in the third semiconductor layer 4 are blocked by the potential barrier of the barrier layer 51 and cannot move to the first semiconductor layer 2.

The material of the barrier layer 51 may be any material having a larger band gap than the third semiconductor layer 4, and may be a compound semiconductor material other than N⁺-GaP or N⁺-GaAsSb. However, if the third semiconductor layer 4 and the barrier layer 51 are made of different materials, crystal defects due to lattice mismatch are likely to occur, and dark current may increase. Therefore, the material of the barrier layer 51 is desirably determined by taking into consideration the lattice mismatch with the materials of the third semiconductor layer 4 and the first semiconductor layer 2.

Fig. 30 is a cross-sectional view illustrating a second specific example of the photoelectric conversion element 1n according to the fourteenth embodiment, and Fig. 31 is a potential diagram of the photoelectric conversion element 1n of Fig. 30. In the photoelectric conversion element 1n of Fig. 30, the barrier layer 51 is made of the same material as the third semiconductor layer 4, and has a higher impurity concentration than the third semiconductor layer 4. For example, when the third semiconductor layer 4 is N-InP, the barrier layer 51 is an N⁺-InP layer. By making the impurity concentration of the barrier layer 51 higher than that of the third semiconductor layer 4, a potential gradient is generated in the barrier layer 51, as illustrated in Fig. 31. Therefore, holes generated by photoelectric conversion in the third semiconductor layer 4 cannot move beyond the barrier layer 51 to the first semiconductor layer 2.

The barrier layer 51 in Fig. 30 is formed of the same material as the third semiconductor layer 4 (for example, InP) although the impurity concentration is different. Therefore, it can maintain crystallinity, suppress dark current, and reduce noise.

Fig. 32 is a circuit diagram illustrating a third specific example of the photoelectric conversion element 1n according to the fourteenth embodiment, and Fig. 33 is a potential diagram of the photoelectric conversion element 1n of Fig. 32. The photoelectric conversion element 1n of Fig. 32 is different from the photoelectric conversion element 1n of Fig. 30 in the material of the third semiconductor layer 4. The third semiconductor layer 4 in the photoelectric conversion element of Fig. 32 is an N-InAlAs. The N-InAlAs has a smaller bandgap than InP. Therefore, the bandgap of the barrier layer 51 is larger than that of the third semiconductor layer 4, and as illustrated in Fig. 33, holes generated by photoelectric conversion in the third semiconductor layer 4 are blocked by the potential barrier of the barrier layer 51 and do not move to the first semiconductor layer 2.

Since N-InAlAs, which is the material of the third semiconductor layer 4, has a lattice match with InP, there is no risk of dark current increasing.

Thus, in the fourteenth embodiment, a potential structure is achieved in which the barrier layer 51 is arranged between the third semiconductor layer 4 that detects visible light and the first semiconductor layer 2 that detects infrared light, and the barrier layer 51 acts as a barrier to carriers generated in the third semiconductor layer 4. Therefore, charges generated by photoelectric conversion in the third semiconductor layer 4 do not enter the first semiconductor layer 2 over the barrier layer 51, and visible light and infrared light can be detected separately. The material of the barrier layer 51 may be different from the material of the third semiconductor layer 4. Alternatively, the impurity concentration of the barrier layer 51 may be higher than that of the third semiconductor layer 4 while the barrier layer 51 and the third semiconductor layer 4 are made of the same material.

### (Fifteenth Embodiment)

Fig. 34 is a cross-sectional view of a photoelectric conversion element 1p according to the fifteenth embodiment, and Fig. 35 is a plan view of the photoelectric conversion element 1p of Fig. 34 viewed from the light incidence surface side. The photoelectric conversion element 1p in Fig. 34 differs from the photoelectric conversion element 1n in Fig. 26 in the structure for discharging electrons generated by photoelectric conversion in the first semiconductor layer 2.

The photoelectric conversion element 1p in Fig. 34 uses the transparent electrode layer 11 disposed on the light incidence surface side of the third semiconductor layer 4 to discharge electrons generated by photoelectric conversion in the first semiconductor layer 2. More specifically, the transparent electrode layer 11 in the photoelectric conversion element 1p in Fig. 34 is in contact with a portion of the barrier layer 51 and is disposed on the light incidence surface side of the third semiconductor layer 4.

The third semiconductor layer 4 in the photoelectric conversion element 1p in Fig. 34 has a hole 4a that penetrates the third semiconductor layer 4. The transparent electrode layer 11 is arranged to cover the side wall surface of the hole 4a and the surface of the barrier layer 51 arranged at the bottom of the hole 4a. The hole 4a is provided according to the location of the pixel, and has a size for one pixel, for example. The side wall surface of the hole 4a is covered with the transparent electrode layer 11, and the inside thereof is further filled with, for example, an insulating member 4b.

Further, the photoelectric conversion element 1p in Fig. 34 includes a second via 18b for discharging electrons. The second via 18b is arranged in the depth direction to penetrate the first substrate 13 and reach inside the second substrate 14. The second via 18b discharges charges generated by photoelectric conversion in the first semiconductor layer 2 to the second substrate 14 side via the transparent electrode layer 11. The second via 18b is arranged in the boundary region of the pixel or outside the pixel region.

As illustrated in the plan view of Fig. 35, electrons photoelectrically converted in the first semiconductor layer 2 are transferred to the transparent electrode layer 11 in contact with the barrier layer 51. The transparent electrode layer 11 is arranged so as to surround the periphery of the pixel, and the second via 18b is arranged in the boundary region of the pixel or outside the pixel region. The electrons transferred from the first semiconductor layer 2 to the transparent electrode layer 11 are discharged to the readout circuit in the second substrate 14 via the second via 18b.

Further, electrons generated by photoelectric conversion in the third semiconductor layer 4 are transferred from the third semiconductor layer 4 to the transparent electrode layer 11, and are discharged from the transparent electrode layer 11 to the readout circuit through the second via 18b.

In this way, in the second embodiment, by bringing a portion of the transparent electrode layer 11 disposed on the light incidence surface side into contact with the barrier layer 51, the electrons generated by photoelectric conversion in the first semiconductor layer 2 can be discharged to the transparent electrode layer 11 side without providing a via for electron discharge. Furthermore, by providing the second via 18b connected to the transparent electrode layer 11 and penetrating the first substrate 13, electrons discharged from the first semiconductor layer 2 to the transparent electrode layer 11 can be discharged to the readout circuit side within the second substrate 14 via the second via 18b.

### (Sixteenth Embodiment)

Fig. 36 is a cross-sectional view of a photoelectric conversion element 1q according to the sixteenth embodiment, and Fig. 37 is a plan view of the photoelectric conversion element 1q of Fig. 36 viewed from the light incidence surface side. A photoelectric conversion element 1q in Fig. 36 has a structure in which a barrier layer 51 is added to the photoelectric conversion element 1g in Fig. 16 described above.

The photoelectric conversion element 1q according to the sixteenth embodiment has a plurality of second electrodes 8 for each pixel and a wiring layer 23 that electrically connects these second electrodes 8. Therefore, charges generated by photoelectric conversion of visible light can be efficiently collected by the second electrode 8, and the sensitivity of visible light can be improved. Further, by arranging the second electrode 8 and the wiring layer 23 in the pixel boundary region, charges can be transferred without reducing the aperture ratio for photoelectric conversion, and sensitivity can be improved.

### (Seventeenth Embodiment)

Fig. 38 is a cross-sectional view of the photoelectric conversion element 1r according to the seventeenth embodiment, and Fig. 39 is a plan view of the photoelectric conversion element 1r of Fig. 38 viewed from the light incidence surface side.

The photoelectric conversion element 1r according to the seventeenth embodiment includes a pixel separation layer 55 arranged in the pixel boundary region. The pixel separation layer 55 penetrates the third semiconductor layer 4, the barrier layer 51, and the first semiconductor layer 2 from the light incidence surface side and extends to the second semiconductor layer 3.

By providing the pixel separation layer 55, it is possible to prevent light incident from the light incidence surface side from entering adjacent pixels, thereby preventing color mixture.

Figs. 40A and 40B are cross-sectional views of a photoelectric conversion element 1s according to a modified example of Fig. 38, and Fig. 41 is a plan view of the photoelectric conversion element 1s of Fig. 40 viewed from the light incidence surface side. Fig. 40Ais a cross-sectional view taken along line A-A in Fig. 41, and Fig. 40B is a cross-sectional view taken along line B-B in Fig. 41.

The photoelectric conversion element 1r in Fig. 39 has the second electrode 8 arranged near the center of each pixel, but the photoelectric conversion element 1s in Fig. 40 has the second electrode 8 arranged near the pixel boundary of each pixel. Since the via 18 for reading out holes is arranged in the pixel boundary region, the pixel separation layer 55 is not arranged at the location where the via 18 is arranged (Fig. 40A).

In this way, in the photoelectric conversion element 1s according to the seventeenth embodiment, the pixel separation layer 55 is provided which penetrates the third semiconductor layer 4, the barrier layer 51, and the first semiconductor layer 2 from the light incidence surface side and extends to the second semiconductor layer 3. Therefore, light incident from the light incidence surface side does not enter the adjacent pixel region, and color mixing can be prevented.

Note that although the photoelectric conversion elements 1r and 1s according to the seventeenth embodiment include the barrier layer 51 between the first semiconductor layer 2 and the second semiconductor layer 3, the barrier layer 51 may be omitted.

### (Eighteenth Embodiment)

Fig. 42 is a cross-sectional view of a photoelectric conversion element 1t according to the eighteenth embodiment, and Fig. 43 is a plan view of the photoelectric conversion element 1t of Fig. 42 viewed from the light incidence surface side. The photoelectric conversion element 1t in Fig. 42, illustrates an example in which the number of pixels for visible light detection and the number of pixels for infrared light detection are different from each other, and the number of pixels for visible light detection is twice larger than the number of pixels for infrared light detection. Fig. 42 has a cross-sectional structure in which a barrier layer 51 is added to the photoelectric conversion element 1k of Fig. 22.

Fig. 44 is a cross-sectional view of a photoelectric conversion element 1u according to a modified example of Fig. 42, and Fig. 45 is a plan view of the photoelectric conversion element 1u of Fig. 44 viewed from the light incidence surface side. The photoelectric conversion element 1u in Fig. 44 illustrates an example in which the number of pixels for visible light detection and the number of pixels for infrared light detection are different from each other, and the number of pixels for visible light detection is twice smaller than the number of pixels for infrared light detection. Fig. 44 has a cross-sectional structure in which a barrier layer 51 is added to the photoelectric conversion element 1m of Fig. 24.

The ratio between the number of pixels for visible light detection and the number of pixels for infrared light detection illustrated in Figs. 42 and 44 is arbitrary.

### (Configuration of Imaging Device)

Fig. 46 is a block diagram illustrating a schematic configuration of an imaging device 40 including the photoelectric conversion elements 1 to 1m according to the first to twelfth embodiments described above. The imaging device 40 in Fig. 46 includes a pixel array unit 41 including at least a portion of the photoelectric conversion elements 1 to 1m according to the first to twelfth embodiments, a row scanning unit 42, a horizontal selection unit 43, a column scanning unit 44, and a system control unit 45.

The pixel array unit 41 has a plurality of pixels PX arranged in a two-dimensional direction (row direction and column direction). Each pixel PX has the photoelectric conversion elements 1 to 1m according to the first to twelfth embodiments. A pixel drive line Lread is arranged for each pixel row consisting of a plurality of pixels PX arranged in the row direction, and a vertical signal line Lsig is arranged for each pixel column consisting of a plurality of pixels PX arranged in the column direction. The pixel drive line Lread transmits a drive signal for driving a corresponding pixel row. Each pixel drive line Lread is connected to the row scanning unit 42.

The row scanning unit 42 includes a shift register, an address decoder, and the like. A plurality of pixel drive lines Lread are connected to the row scanning unit 42. The row scanning unit 42 sequentially outputs drive signals to the plurality of pixel drive lines Lread. As a result, a plurality of pixel rows in the pixel array unit 41 are driven in turn.

When each pixel row in the pixel array unit 41 receives a drive signal from the corresponding pixel drive line Lread, it outputs the pixel signal to the corresponding vertical signal line Lsig. A plurality of pixel signals are output to a plurality of vertical signal lines Lsig corresponding to a plurality of pixels PX constituting a pixel row at the same timing. These pixel signals are input to the horizontal selection unit 43.

The horizontal selection unit 43 includes a comparator, a counter, a switch, and the like, and performs analog-to-digital conversion on a plurality of pixel signals output from a plurality of pixels PX constituting a pixel row based on a control signal from the system control unit 45 to generate pixel data.

The column scanning unit 44 includes a shift register, an address decoder, and the like. The column scanning unit 44 switches and controls the switches of the horizontal selection unit 43 to sequentially select and output a plurality of pieces of pixel data corresponding to a plurality of pixels PX constituting a pixel row.

The system control unit 45 receives externally supplied clocks, data instructing operation modes, and the like, and supplies various clocks and data to each unit in the imaging device 40. The system control unit 45 also includes a timing generator that generates various timing signals, and supplies the various timing signals generated by the timing generator to each unit in the imaging device 40.

The photoelectric conversion element 1 according to the first to eighteenth embodiments is constructed by bonding the first substrate 13 and the second substrate 14 with the Cu-Cu bonding 17 or the like. At least a portion of the pixel array unit 41 in Fig. 46 is arranged on the first substrate 13. At least a portion of the row scanning unit 42, horizontal selection unit 43, column scanning unit 44, and system control unit 45 other than the pixel array unit 41 in Fig. 46 are arranged on the second substrate 14.

Fig. 47 is a diagram schematically illustrating how the first substrate 13 and the second substrate 14 are bonded together. The first substrate 13 and the second substrate 14 are bonded together by the Cu-Cu bonding 17, the vias 18, bumps, and the like, as described above.

### <Application to Mobile Object>

The technology of the present disclosure (the present technology) can be applied to various products. For example, the technique according to the present disclosure may be realized as a device mounted on any type of moving body such as an automobile, an electric automobile, a hybrid electric automobile, a motorcycle, a bicycle, a personal mobility device, an airplane, a drone, a ship, a robot, or the like.

Fig. 48 is a block diagram illustrating a schematic configuration example of a vehicle control system, which is an example of a moving body control system to which the technique according to the present disclosure can be applied.

The vehicle control system 12000 includes a plurality of electronic control units connected to each other via a communication network 12001. In the example illustrated in Fig. 48, the vehicle control system 12000 includes a drive system control unit 12010, a body system control unit 12020, a vehicle exterior information detection unit 12030, a vehicle interior information detection unit 12040, and an integrated control unit 12050. As a functional configuration of the integrated control unit 12050, a microcomputer 12051, an audio/image output unit 12052, and an in-vehicle network I/F (interface) 12053 are illustrated.

The drive system control unit 12010 controls an operation of an apparatus related to a drive system of a vehicle according to various programs. For example, the drive system control unit 12010 functions as a driving force generator for generating a driving force of a vehicle such as an internal combustion engine or a driving motor, a driving force transmission mechanism for transmitting a driving force to wheels, a steering mechanism for adjusting a turning angle of a vehicle, and a control apparatus such as a braking apparatus that generates a braking force of a vehicle.

The body system control unit 12020 controls operations of various devices mounted in the vehicle body according to various programs. For example, the body system control unit 12020 functions as a control device of a keyless entry system, a smart key system, a power window device, or various lamps such as a headlamp, a back lamp, a brake lamp, a turn signal, and a fog lamp. In this case, radio waves transmitted from a portable device that substitutes for a key or signals of various switches may be input to the body system control unit 12020. The body system control unit 12020 receives inputs of the radio waves or signals and controls a door lock device, a power window device, and a lamp of the vehicle.

The vehicle exterior information detection unit 12030 detects information on the outside of the vehicle having the vehicle control system 12000 mounted thereon. For example, an imaging unit 12031 is connected to the vehicle exterior information detection unit 12030. The vehicle exterior information detection unit 12030 causes the imaging unit 12031 to capture an image of the outside of the vehicle and receives the captured image. The vehicle exterior information detection unit 12030 may perform object detection processing or distance detection processing for peoples, cars, obstacles, signs, and letters on the road on the basis of the received image.

The imaging unit 12031 is an optical sensor that receives light and outputs an electrical signal according to the amount of the received light. The imaging unit 12031 can also output the electrical signal as an image or distance measurement information. In addition, the light received by the imaging unit 12031 may be visible light or invisible light such as infrared light.

The vehicle interior information detection unit 12040 detects information on the inside of the vehicle. For example, a driver state detection unit 12041 that detects a driver's state is connected to the vehicle interior information detection unit 12040. The driver state detection unit 12041 includes, for example, a camera that captures an image of a driver, and the vehicle interior information detection unit 12040 may calculate a degree of fatigue or concentration of the driver or may determine whether or not the driver is dozing on the basis of detection information input from the driver state detection unit 12041.

The microcomputer 12051 can calculate a control target value of the driving force generation device, the steering mechanism, or the braking device on the basis of information inside and outside of the vehicle acquired by the vehicle exterior information detection unit 12030 or the vehicle interior information detection unit 12040, and output a control command to the drive system control unit 12010. For example, the microcomputer 12051 can perform cooperative control for the purpose of realizing functions of an ADAS (advanced driver assistance system) including vehicle collision avoidance, impact mitigation, following traveling based on an inter-vehicle distance, vehicle speed maintenance driving, vehicle collision warning, vehicle lane deviation warning, and the like.

Further, the microcomputer 12051 can perform cooperative control for the purpose of automated driving or the like in which autonomous travel is performed without depending on operations of the driver, by controlling the driving force generator, the steering mechanism, or the braking device and the like on the basis of information about the surroundings of the vehicle, the information being acquired by the vehicle exterior information detection unit 12030 or the vehicle interior information detection unit 12040.

In addition, the microcomputer 12051 can output a control command to the body system control unit 12030 based on the information outside the vehicle acquired by the vehicle exterior information detection unit 12030. For example, the microcomputer 12051 can perform coordinated control for the purpose of antiglare such as switching a high beam to a low beam by controlling a headlamp according to a position of a preceding vehicle or an oncoming vehicle detected by the vehicle exterior information detection unit 12030.

The audio/image output unit 12052 transmits an output signal of at least one of sound and an image to an output device capable of visually or audibly notifying a passenger or the outside of the vehicle of information. In the example of Fig. 48, an audio speaker 12061, a display unit 12062, and an instrument panel 12063 are illustrated as examples of the output device. The display unit 12062 may include at least one of an on-board display and a head-up display, for example.

Fig. 49 is a diagram illustrating an example of an installation position of the imaging unit 12031.

In Fig. 49, the imaging unit 12031 includes imaging units 12101, 12102, 12103, 12104, and 12105.

The imaging units 12101, 12102, 12103, 12104, and 12105 are provided at, for example, positions of a front nose, side mirrors, a rear bumper, a back door, an upper portion of a vehicle internal front windshield, and the like of the vehicle 12100. The imaging unit 12101 provided on a front nose and the imaging unit 12105 provided in an upper portion of the vehicle internal front windshield mainly acquire images in front of the vehicle 12100. The imaging units 12102 and 12103 provided in the side mirrors mainly acquire images on the lateral sides of the vehicle 12100. The imaging unit 12104 included in the rear bumper or the back door mainly acquires an image of an area behind the vehicle 12100. The imaging unit 12105 included in the upper portion of the windshield inside the vehicle is mainly used for detection of a preceding vehicle, a pedestrian, an obstacle, a traffic signal, a traffic sign, a lane, or the like.

Fig. 49 illustrates an example of imaging ranges of the imaging units 12101 to 12104. An imaging range 12111 indicates an imaging range of the imaging unit 12101 provided at the front nose, imaging ranges 12112 and 12113 respectively indicate the imaging ranges of the imaging units 12102 and 12103 provided at the side-view mirrors, and an imaging range 12114 indicates the imaging range of the imaging unit 12104 provided at the rear bumper or the back door. For example, by superimposing image data captured by the imaging units 12101 to 12104, it is possible to obtain a bird's-eye view image viewed from the upper side of the vehicle 12100.

At least one of the imaging units 12101 to 12104 may have a function for obtaining distance information. For example, at least one of the imaging units 12101 to 12104 may be a stereo camera constituted by a plurality of imaging elements or may be an imaging element that has pixels for phase difference detection.

For example, the microcomputer 12051 can extract, particularly, a closest three-dimensional object on a path through which the vehicle 12100 is traveling, which is a three-dimensional object traveling at a predetermined speed (for example, 0 km/h or higher) in the substantially same direction as the vehicle 12100, as a preceding vehicle by obtaining a distance to each three-dimensional object in the imaging ranges 12111 to 12114 and temporal change in the distance (a relative speed with respect to the vehicle 12100) based on distance information obtained from the imaging units 12101 to 12104. The microcomputer 12051 can also set a following distance to the preceding vehicle to be maintained in advance and perform automatic brake control (including following stop control) and automatic acceleration control (including following start control). It is therefore possible to perform coordinated control for the purpose of, for example, automated driving in which the vehicle travels in an automated manner without requiring the driver to perform operations.

For example, the microcomputer 12051 can classify and extract three-dimensional data regarding three-dimensional objects into two-wheeled vehicles, normal vehicles, large vehicles, pedestrians, and other three-dimensional objects such as electric poles based on distance information obtained from the imaging units 12101 to 12104 and can use the three-dimensional data to perform automated avoidance of obstacles. For example, the microcomputer 12051 differentiates surrounding obstacles of the vehicle 12100 into obstacles which can be viewed by the driver of the vehicle 12100 and obstacles which are difficult to view. Then, the microcomputer 12051 determines a collision risk indicating the degree of risk of collision with each obstacle, and when the collision risk is equal to or higher than a set value and there is a possibility of collision, an alarm is output to the driver through the audio speaker 12061 or the display unit 12062, forced deceleration or avoidance steering is performed through the drive system control unit 12010, and thus it is possible to perform driving support for collision avoidance.

At least one of the imaging units 12101 to 12104 may be an infrared camera that detects infrared rays. For example, the microcomputer 12051 can recognize a pedestrian by determining whether there is a pedestrian in the captured image of the imaging units 12101 to 12104. Such pedestrian recognition is performed by, for example, a procedure in which feature points in the captured images of the imaging units 12101 to 12104 as infrared cameras are extracted and a procedure in which pattern matching processing is performed on a series of feature points indicating an outline of an object to determine whether or not the object is a pedestrian. When the microcomputer 12051 determines that there is a pedestrian in the captured images of the imaging units 12101 to 12104 and the pedestrian is recognized, the audio/image output unit 12052 controls the display unit 12062 so that a square contour line for emphasis is superimposed and displayed with the recognized pedestrian. In addition, the audio/image output unit 12052 may control the display unit 12062 so that an icon indicating a pedestrian or the like is displayed at a desired position.

An example of the vehicle control system to which the technology according to the present disclosure can be applied has been described above. The technique according to the present disclosure is applicable to the imaging unit 12031 or the like among the above-described configurations. Specifically, the imaging device 40 of the present disclosure is applicable to the imaging unit 12031. By applying the technique according to the present disclosure to the imaging unit 12031, an image can be more clearly captured, thereby reducing driver fatigue.

The present technique can also take on the following configurations.
(1) A photoelectric conversion element including: a first semiconductor layer of a first conductivity type containing a compound semiconductor material;
   a second semiconductor layer of a first conductivity type containing a compound semiconductor material having a larger band gap than the first semiconductor layer and stacked on a side of the first semiconductor layer opposite to the light incidence surface;
   a third semiconductor layer of a first conductivity type containing a compound semiconductor material having a larger band gap than the first semiconductor layer and stacked on the light incidence surface side of the first semiconductor layer;
   a first diffusion layer of a second conductivity type disposed to penetrate the second semiconductor layer from a side of the second semiconductor layer opposite to the light incidence surface and extend into the first semiconductor layer;
   a first electrode in contact with the first diffusion layer on the side of the second semiconductor layer opposite to the light incidence surface;
   a second diffusion layer of a second conductivity type disposed in a depth direction of the third semiconductor layer from a light incidence surface side of the third semiconductor layer;
   a second electrode in contact with the second diffusion layer on the light incidence surface side of the third semiconductor layer; and
   an insulating layer disposed between the second electrode and the third semiconductor layer.
(2) The photoelectric conversion element according to (1), wherein the first diffusion layer, the second diffusion layer, the first electrode, and the second electrode are provided for each pixel, and
   each of the first semiconductor layer, the second semiconductor layer, and the third semiconductor layer is arranged across a plurality of pixel regions.
(3) The photoelectric conversion element according to (1), wherein the first diffusion layer and the first electrode are provided m (m is an integer of 1 or more) for each pixel, or are provided for every m (m is an integer of 1 or more) pixels, and
   each of the first semiconductor layer, the second semiconductor layer, and the third semiconductor layer is arranged across a plurality of pixel regions.
(4) The photoelectric conversion element according to any one of (1) to (3), wherein the second diffusion layer and the second electrode are provided n (n is an integer of 1 or more) for each pixel, or are provided for every n (n is an integer of 1 or more) pixels, and
   each of the first semiconductor layer, the second semiconductor layer, and the third semiconductor layer is arranged across a plurality of pixel regions.
(5) The photoelectric conversion element according to (4), wherein a plurality of the second diffusion layers and a corresponding plurality of the second electrodes are provided for each pixel, the photoelectric conversion element further including:
   a via electrically connected to the plurality of second electrodes in the same pixel and penetrating the third semiconductor layer, the first semiconductor layer, and the second semiconductor layer; and
   a wiring layer electrically connecting the plurality of second electrodes in the same pixel to the corresponding via.
(6) The photoelectric conversion element according to (5), further including: a via provided for a plurality of pixels, electrically connected to the plurality of second electrodes in the plurality of pixels, and penetrating the third semiconductor layer, the first semiconductor layer, and the second semiconductor layer, wherein all the second electrodes in the plurality of pixels are electrically connected to the via.
(7) The photoelectric conversion element according to any one of (1) to (5), further including: a first readout circuit disposed on the side of the second semiconductor layer opposite to the light incidence surface and electrically connected to the first electrode;
   a via electrically connected to the second electrode and penetrating the third semiconductor layer, the first semiconductor layer, and the second semiconductor layer; and
   a second readout circuit disposed on the side of the second semiconductor layer opposite to the light incidence surface and electrically connected to the via.
(8) The photoelectric conversion element according to (7), further including: a first substrate on which the first semiconductor layer, the second semiconductor layer, the third semiconductor layer, the first diffusion layer, the second diffusion layer, the first electrode, and the second electrode are arranged;
   a second substrate on which the first readout circuit and the second readout circuit are arranged, and a readout circuit that generates a pixel signal based on charges taken out by the first readout circuit and charges taken out by the second readout circuit is arranged; and
   a plurality of bonding portions that bonds the first substrate and the second substrate and transmits and receives a plurality of signals between the first substrate and the second substrate, wherein
   the via is connected to the corresponding bonding portion.
(9) The photoelectric conversion element according to (7), further including: a first substrate on which the first semiconductor layer, the second semiconductor layer, the third semiconductor layer, the first diffusion layer, the second diffusion layer, the first electrode, and the second electrode are arranged; and
   a second substrate on which the first readout circuit and the second readout circuit are arranged, and which generates a pixel signal based on charges taken out by the first readout circuit and charges taken out by the second readout circuit, wherein
   the via extends through the first substrate to the second readout circuit in the second substrate.
(10) The photoelectric conversion element according to any one of (7) to (9), wherein a voltage applied to the first readout circuit is set independently of a voltage applied to the second readout circuit.
(11) The photoelectric conversion element according to any one of (7) to (10), wherein the via includes:
   a first via that transfers first charges generated by photoelectric conversion to the second readout circuit; and
   a second via that discharges second charges generated by photoelectric conversion.
(12) The photoelectric conversion element according to (11), wherein the first via and the second via are provided for every plurality of pixels,
   the first via discharges the first charges of the corresponding plurality of pixels, and
   the second via discharges the second charges of the corresponding plurality of pixels.
(13) The photoelectric conversion element according to any one of (1) to (12), wherein the second diffusion layer is arranged to penetrate the third semiconductor layer from a light incidence surface side of the third semiconductor layer and extend into the first semiconductor layer.
(14) The photoelectric conversion element according to (13), wherein the first electrode and the second electrode collect charges obtained by photoelectrically converting light in the same wavelength band.
(15) The photoelectric conversion element according to any one of (1) to (12), wherein the second diffusion layer is arranged so as to remain inside the third semiconductor layer without penetrating the third semiconductor layer from the light incidence surface side of the third semiconductor layer.
(16) The photoelectric conversion element according to (15), wherein the first electrode and the second electrode collect charges obtained by photoelectrically converting light in different wavelength bands.
(17) The photoelectric conversion element according to (15) or (16), further including: a barrier layer disposed between the first semiconductor layer and the third semiconductor layer to block charges generated by photoelectric conversion in the third semiconductor layer.
(18) The photoelectric conversion element according to (17), wherein the barrier layer contains a material with a larger band gap than the third semiconductor layer.
(19) The photoelectric conversion element according to (17), wherein the barrier layer contains the same material as the third semiconductor layer and contains more impurities of the same conductivity type as the third semiconductor layer than the third semiconductor layer.
(20) The photoelectric conversion element according to (17) or (18), wherein the barrier layer contains a different material from the third semiconductor layer and contains more impurities of the same conductivity type as the third semiconductor layer than the third semiconductor layer.
(21) The photoelectric conversion element according to any one of (17) to (20), further including: a third via penetrating the third semiconductor layer and extending to the barrier layer.
(22) The photoelectric conversion element according to (21), wherein the third via discharges charges that are generated by photoelectric conversion in the first semiconductor layer but are not to be read out to the light incidence surface side.
(23) The photoelectric conversion element according to (21) or (22), further including: a fourth via that discharges charges transferred to the light incidence surface side through the third via to a side opposite to the light incidence surface.
(24) The photoelectric conversion element according to any one of (17) to (20), further including: a transparent electrode layer that is in contact with a portion of the barrier layer and is disposed on the light incidence surface side of the third semiconductor layer.
(25) The photoelectric conversion element according to (24), further including: a hole arranged to penetrate the third semiconductor layer, wherein
   the transparent electrode layer is arranged to cover a side wall surface of the hole and a surface of the barrier layer arranged at a bottom of the hole.
(26) The photoelectric conversion element according to (25), wherein the hole is provided according to a location of the pixel, and
   a diameter of the hole corresponds to a size of one pixel.
(27) The photoelectric conversion element according to any one of (1) to (26), further including: a pixel separation layer arranged to penetrate the first semiconductor layer and the third semiconductor layer along a pixel boundary region.
(28) The photoelectric conversion element according to any one of (1) to (27), wherein the compound semiconductor material of the second semiconductor layer is the same as the compound semiconductor material of the third semiconductor layer.
(29) The photoelectric conversion element according to any one of (1) to (28), further including: a fourth semiconductor layer of the first conductivity type, which is disposed on the light incidence surface side of the third semiconductor layer, has a higher impurity concentration than the third semiconductor layer, and is disposed electrically separated from the second electrode; and
   a third electrode made of a transparent electrode material and electrically connected to the fourth semiconductor layer.
(30) An imaging device including: a pixel array unit having a plurality of pixels, each of the plurality of pixels includes:
   a first semiconductor layer of a first conductivity type containing a compound semiconductor material that performs photoelectric conversion;
   a second semiconductor layer of a first conductivity type containing a compound semiconductor material having a larger band gap than the first semiconductor layer and stacked on the side of the first semiconductor layer opposite to the light incidence surface;
   a third semiconductor layer of a first conductivity type containing a compound semiconductor material having a larger band gap than the first semiconductor layer and stacked on the light incidence surface side of the first semiconductor layer;
   a first diffusion layer of a second conductivity type disposed to penetrate the second semiconductor layer from a side of the second semiconductor layer opposite to the light incidence surface and extend into the first semiconductor layer;
   a first electrode in contact with the first diffusion layer on the side of the second semiconductor layer opposite to the light incidence surface;
   a second diffusion layer of a second conductivity type disposed in a depth direction of the third semiconductor layer from a light incidence surface side of the third semiconductor layer;
   a second electrode in contact with the second diffusion layer on the light incidence surface side of the third semiconductor layer; and
   an insulating layer disposed between the second electrode and the third semiconductor layer.

Aspects of the present disclosure are not limited to the aforementioned individual embodiments and include various modifications that those skilled in the art can achieve, and effects of the present disclosure are also not limited to the details described above. In other words, various additions, modifications, and partial deletion can be made without departing from the conceptual idea and the gist of the present disclosure that can be derived from the details defined in the claims and the equivalents thereof.

### [Reference Signs List]

- 1, 1a, 1b, 1c, 1d, 1e, 1f, 1g, 1h, 1i, 1j, 1k 1m: Photoelectric conversion element
- 2: First semiconductor layer
- 3: Second semiconductor layer
- 4: Third semiconductor layer
- 5: First diffusion layer
- 6: First electrode
- 7: Second diffusion layer
- 8: Second electrode
- 9: Insulating layer
- 10: Fourth semiconductor layer
- 11: Transparent electrode layer
- 12: Protective film
- 13: First substrate
- 14: Second substrate
- 15: First readout circuit
- 16: Wiring layer
- 17: Cu-Cu bonding
- 18: Via
- 18a: First via
- 18b: Second via
- 19: Second readout circuit
- 20: Trench
- 21: Insulating film
- 22: Conductive film
- 23: Wiring layer
- 30: Semiconductor layer
- 31: Adhesive layer
- 32: Support substrate
- 33: Insulating film
- 34: Buried insulating film
- 35: Adhesive layer
- 36: Insulating film
- 37: Support substrate
- 38: Insulating film
- 39: Wiring layer
- 40: Imaging device
- 41: Pixel array unit
- 42: Row scanning unit
- 43: Horizontal selection unit
- 44: Column scanning unit
- 45: System control unit

## Claims

1. A photoelectric conversion element comprising:
a first semiconductor layer (2) of a first conductivity type containing a compound semiconductor material;
a second semiconductor layer (3) of a first conductivity type containing a compound semiconductor material having a larger band gap than the first semiconductor layer and stacked on a side of the first semiconductor layer opposite to the light incidence surface;
a third semiconductor layer (4) of a first conductivity type containing a compound semiconductor material having a larger band gap than the first semiconductor layer and stacked on the light incidence surface side of the first semiconductor layer;
a first diffusion layer (5) of a second conductivity type disposed to penetrate the second semiconductor layer from a side of the second semiconductor layer opposite to the light incidence surface and extend into the first semiconductor layer;
a first electrode (6) in contact with the first diffusion layer on the side of the second semiconductor layer opposite to the light incidence surface;
a second diffusion layer (7) of a second conductivity type disposed in a depth direction of the third semiconductor layer from a light incidence surface side of the third semiconductor layer;
a second electrode (8) in contact with the second diffusion layer on the light incidence surface side of the third semiconductor layer; and
an insulating layer (9) disposed between the second electrode and the third semiconductor layer.

2. The photoelectric conversion element according to claim 1, wherein
the first diffusion layer, the second diffusion layer, the first electrode, and the second electrode are provided for each pixel, and
each of the first semiconductor layer, the second semiconductor layer, and the third semiconductor layer is arranged across a plurality of pixel regions.

3. The photoelectric conversion element according to claim 1, wherein
the first diffusion layer and the first electrode are provided m (m is an integer of 1 or more) for each pixel, or are provided for every m (m is an integer of 1 or more) pixels, and
each of the first semiconductor layer, the second semiconductor layer, and the third semiconductor layer is arranged across a plurality of pixel regions.

4. The photoelectric conversion element according to any of the preceding claims, wherein
the second diffusion layer and the second electrode are provided n (n is an integer of 1 or more) for each pixel, or are provided for every n (n is an integer of 1 or more) pixels, and
each of the first semiconductor layer, the second semiconductor layer, and the third semiconductor layer is arranged across a plurality of pixel regions, wherein a plurality of the second diffusion layers and a corresponding plurality of the second electrodes are provided for each pixel, the photoelectric conversion element further comprising:
a via electrically connected to the plurality of second electrodes in the same pixel and penetrating the third semiconductor layer, the first semiconductor layer, and the second semiconductor layer; and
a wiring layer electrically connecting the plurality of second electrodes in the same pixel to the corresponding via.

5. The photoelectric conversion element according to claim 4, further comprising:
a via provided for a plurality of pixels, electrically connected to the plurality of second electrodes in the plurality of pixels, and penetrating the third semiconductor layer, the first semiconductor layer, and the second semiconductor layer, wherein
all the second electrodes in the plurality of pixels are electrically connected to the via.

6. The photoelectric conversion element according to any of claims 1 to 4, further comprising:
a first readout circuit disposed on the side of the second semiconductor layer opposite to the light incidence surface and electrically connected to the first electrode;
a via electrically connected to the second electrode and penetrating the third semiconductor layer, the first semiconductor layer, and the second semiconductor layer; and
a second readout circuit disposed on the side of the second semiconductor layer opposite to the light incidence surface and electrically connected to the via.

7. The photoelectric conversion element according to claim 6, further comprising:
i) a first substrate on which the first semiconductor layer, the second semiconductor layer, the third semiconductor layer, the first diffusion layer, the second diffusion layer, the first electrode, and the second electrode are arranged;
a second substrate on which the first readout circuit and the second readout circuit are arranged, and a readout circuit that generates a pixel signal based on charges taken out by the first readout circuit and charges taken out by the second readout circuit is arranged; and
a plurality of bonding portions that bonds the first substrate and the second substrate and transmits and receives a plurality of signals between the first substrate and the second substrate, wherein
the via is connected to the corresponding bonding portion,
or
ii) a first substrate on which the first semiconductor layer, the second semiconductor layer, the third semiconductor layer, the first diffusion layer, the second diffusion layer, the first electrode, and the second electrode are arranged; and
a second substrate on which the first readout circuit and the second readout circuit are arranged, and which generates a pixel signal based on charges taken out by the first readout circuit and charges taken out by the second readout circuit, wherein
the via extends through the first substrate to the second readout circuit in the second substrate.

8. The photoelectric conversion element according to any of claims 6 to 7, wherein the via includes:
a first via that transfers first charges generated by photoelectric conversion to the second readout circuit; and
a second via that discharges second charges generated by photoelectric conversion, wherein
the first via and the second via are provided for every plurality of pixels,
the first via discharges the first charges of the corresponding plurality of pixels, and
the second via discharges the second charges of the corresponding plurality of pixels.

9. The photoelectric conversion element according to any of the preceding claims, wherein
the second diffusion layer is arranged to penetrate the third semiconductor layer from a light incidence surface side of the third semiconductor layer and extend into the first semiconductor layer.

10. The photoelectric conversion element according to any of claims 1 to 8, wherein the second diffusion layer is arranged so as to remain inside the third semiconductor layer without penetrating the third semiconductor layer from the light incidence surface side of the third semiconductor layer.

11. The photoelectric conversion element according to the preceding claim, further comprising:
a barrier layer disposed between the first semiconductor layer and the third semiconductor layer to block charges generated by photoelectric conversion in the third semiconductor layer, wherein
the barrier layer contains a material with a larger band gap than the third semiconductor layer, and
the barrier layer contains
i) the same material as the third semiconductor layer and contains more impurities of the same conductivity type as the third semiconductor layer than the third semiconductor layer, or
ii) a different material from the third semiconductor layer and contains more impurities of the same conductivity type as the third semiconductor layer than the third semiconductor layer.

12. The photoelectric conversion element according to the preceding claim, further comprising:
a third via penetrating the third semiconductor layer and extending to the barrier layer.

13. The photoelectric conversion element according to the preceding claim, further comprising:
a fourth via that discharges charges transferred to the light incidence surface side through the third via to a side opposite to the light incidence surface.

14. The photoelectric conversion element according to claim 11, further comprising:
a transparent electrode layer that is in contact with a portion of the barrier layer and is disposed on the light incidence surface side of the third semiconductor layer; and
a hole arranged to penetrate the third semiconductor layer, wherein
the transparent electrode layer is arranged to cover a side wall surface of the hole and a surface of the barrier layer arranged at a bottom of the hole.

15. The photoelectric conversion element according to any of the preceding claims, further comprising:
a fourth semiconductor layer of the first conductivity type, which is disposed on the light incidence surface side of the third semiconductor layer, has a higher impurity concentration than the third semiconductor layer, and is disposed electrically separated from the second electrode; and
a third electrode made of a transparent electrode material and electrically connected to the fourth semiconductor layer.

## Patentansprüche

1. Photoelektrisches Umwandlungselement, umfassend:
eine erste Halbleiterschicht (2) eines ersten Leitfähigkeitstyps, die ein Verbindungshalbleitermaterial enthält;
eine zweite Halbleiterschicht (3) eines ersten Leitfähigkeitstyps, die ein Verbindungshalbleitermaterial enthält, das eine größere Bandlücke als die erste Halbleiterschicht aufweist, und auf einer Seite der ersten Halbleiterschicht gegenüber der Lichteinfallsoberfläche gestapelt ist;
eine dritte Halbleiterschicht (4) eines ersten Leitfähigkeitstyps, die ein Verbindungshalbleitermaterial enthält, das eine größere Bandlücke als die erste Halbleiterschicht aufweist, und auf der Lichteinfallsoberflächenseite der ersten Halbleiterschicht gestapelt ist;
eine erste Diffusionsschicht (5) eines zweiten Leitfähigkeitstyps, die so angeordnet ist, dass sie die zweite Halbleiterschicht von einer der Seite der zweiten Halbleiterschicht aus, die der Lichteinfallsoberfläche gegenüberliegt, durchdringt und sich in die erste Halbleiterschicht erstreckt;
eine erste Elektrode (6) in Kontakt mit der ersten Diffusionsschicht auf der Seite der zweiten Halbleiterschicht, die der Lichteinfallsoberfläche gegenüberliegt;
eine zweite Diffusionsschicht (7) eines zweiten Leitfähigkeitstyps, die in einer Tiefenrichtung der dritten Halbleiterschicht von einer Lichteinfallsoberflächenseite der dritten Halbleiterschicht aus angeordnet ist;
eine zweite Elektrode (8) in Kontakt mit der zweiten Diffusionsschicht auf der Lichteinfallsoberflächenseite der dritten Halbleiterschicht; und
eine Isolierschicht (9), die zwischen der zweiten Elektrode und der dritten Halbleiterschicht angeordnet ist.

2. Photoelektrisches Umwandlungselement nach Anspruch 1, wobei
die erste Diffusionsschicht, die zweite Diffusionsschicht, die erste Elektrode und die zweite Elektrode für jedes Pixel bereitgestellt sind, und
jede der ersten Halbleiterschicht, der zweiten Halbleiterschicht und der dritten Halbleiterschicht über eine Vielzahl von Pixelregionen angeordnet sind.

3. Photoelektrisches Umwandlungselement nach Anspruch 1, wobei
die erste Diffusionsschicht und die erste Elektrode m (m ist eine ganze Zahl von 1 oder mehr) für jedes Pixel bereitgestellt sind, oder für alle m (m ist eine ganze Zahl von 1 oder mehr) Pixel bereitgestellt sind, und
jede der ersten Halbleiterschicht, der zweiten Halbleiterschicht und der dritten Halbleiterschicht über eine Vielzahl von Pixelregionen angeordnet sind.

4. Photoelektrisches Umwandlungselement nach einem der vorstehenden Ansprüche, wobei
die zweite Diffusionsschicht und die zweite Elektrode n (n ist eine ganze Zahl von 1 oder mehr) für jedes Pixel bereitgestellt sind, oder für alle n (n ist eine ganze Zahl von 1 oder mehr) Pixel bereitgestellt sind, und
jede der ersten Halbleiterschicht, der zweiten Halbleiterschicht und der dritten Halbleiterschicht über eine Vielzahl von Pixelregionen angeordnet sind, wobei eine Vielzahl der zweiten Diffusionsschichten und eine entsprechende Vielzahl der zweiten Elektroden für jedes Pixel bereitgestellt sind, das photoelektrische Umwandlungselement ferner umfassend:
eine Durchkontaktierung, die elektrisch mit der Vielzahl der zweiten Elektroden in demselben Pixel verbunden ist und die dritte Halbleiterschicht, die erste Halbleiterschicht und die zweite Halbleiterschicht durchdringt; und
eine Verdrahtungsschicht, welche die Vielzahl der zweiten Elektroden in demselben Pixel mit der entsprechenden Durchkontaktierung elektrisch verbindet.

5. Photoelektrisches Umwandlungselement nach Anspruch 4, ferner umfassend:
ein Durchkontaktierung, die für eine Vielzahl von Pixeln bereitgestellt ist, die elektrisch mit der Vielzahl von zweiten Elektroden in der Vielzahl von Pixeln verbunden ist und die dritte Halbleiterschicht, die erste Halbleiterschicht und die zweite Halbleiterschicht durchdringt, wobei
alle zweiten Elektroden in der Vielzahl von Pixeln elektrisch mit der Durchkontaktierung verbunden sind.

6. Photoelektrisches Umwandlungselement nach einem der Ansprüche 1 bis 4, ferner umfassend:
eine erste Ausleseschaltung, die auf der Seite der zweiten Halbleiterschicht, die der Lichteinfallsoberfläche gegenüberliegt, angeordnet ist und elektrisch mit der ersten Elektrode verbunden ist;
eine Durchkontaktierung, die elektrisch mit der zweiten Elektrode verbunden ist und die dritte Halbleiterschicht, die erste Halbleiterschicht und die zweite Halbleiterschicht durchdringt; und
eine zweite Ausleseschaltung, die auf der Seite der zweiten Halbleiterschicht, die der Lichteinfallsoberfläche gegenüberliegt, angeordnet ist und elektrisch mit der Durchkontaktierung verbunden ist.

7. Photoelektrisches Umwandlungselement nach Anspruch 6, ferner umfassend:
i) ein erstes Substrat, auf dem die erste Halbleiterschicht, die zweite Halbleiterschicht, die dritte Halbleiterschicht, die erste Diffusionsschicht, die zweite Diffusionsschicht, die erste Elektrode und die zweite Elektrode angeordnet sind;
ein zweites Substrat, auf dem die erste Ausleseschaltung und die zweite Ausleseschaltung angeordnet sind, und eine Ausleseschaltung, die basierend auf den von der ersten Ausleseschaltung entnommenen Ladungen und den von der zweiten Ausleseschaltung entnommenen Ladungen ein Pixelsignal erzeugt, angeordnet ist; und
eine Vielzahl von Bondingabschnitten, die das erste Substrat und das zweite Substrat bonden und eine Vielzahl von Signalen zwischen dem ersten Substrat und dem zweiten Substrat übertragen und empfangen, wobei
die Durchkontaktierung mit dem entsprechenden Bondingabschnitt verbunden ist,
oder
ii) ein erstes Substrat, auf dem die erste Halbleiterschicht, die zweite Halbleiterschicht, die dritte Halbleiterschicht, die erste Diffusionsschicht, die zweite Diffusionsschicht, die erste Elektrode und die zweite Elektrode angeordnet sind; und
ein zweites Substrat, auf dem die erste Ausleseschaltung und die zweite Ausleseschaltung angeordnet sind, und das basierend auf den von der ersten Ausleseschaltung entnommenen Ladungen und von der zweiten Ausleseschaltung entnommenen Ladungen ein Pixelsignal erzeugt, wobei
die Durchkontaktierung sich durch das erste Substrat zu der zweiten Ausleseschaltung in dem zweiten Substrat erstreckt.

8. Photoelektrisches Umwandlungselement nach einem der Ansprüche 6 bis 7, wobei die Durchkontaktierung einschließt:
eine erste Durchkontaktierung, die erste Ladungen, die durch photoelektrische Umwandlung erzeugt werden, an die zweite Ausleseschaltung überträgt; und
eine zweite Durchkontaktierung, die zweite Ladungen, die durch photoelektrische Umwandlung erzeugt werden, entlädt, wobei
die erste Durchkontaktierung und die zweite Durchkontaktierung für jede Vielzahl von Pixeln bereitgestellt sind,
die erste Durchkontaktierung die ersten Ladungen der entsprechenden Vielzahl von Pixeln entlädt, und
die zweite Durchkontaktierung die zweiten Ladungen der entsprechenden Vielzahl von Pixeln entlädt.

9. Photoelektrisches Umwandlungselement nach einem der vorstehenden Ansprüche, wobei
die zweite Diffusionsschicht so angeordnet ist, dass sie die dritte Halbleiterschicht von einer Lichteinfallsoberflächenseite der dritten Halbleiterschicht aus durchdringt und sich in die erste Halbleiterschicht erstreckt.

10. Photoelektrisches Umwandlungselement nach einem der Ansprüche 1 bis 8, wobei die zweite Diffusionsschicht so angeordnet ist, dass sie innerhalb der dritten Halbleiterschicht verbleibt, ohne die dritte Halbleiterschicht von der Lichteinfallsoberflächenseite der dritten Halbleiterschicht aus zu durchdringen.

11. Photoelektrisches Umwandlungselement nach dem vorstehenden Anspruch, ferner umfassend:
eine Sperrschicht, die zwischen der ersten Halbleiterschicht und der dritten Halbleiterschicht angeordnet ist, um durch photoelektrische Umwandlung in der dritten Halbleiterschicht erzeugte Ladungen zu blockieren, wobei
die Sperrschicht ein Material mit einer größeren Bandlücke als die dritte Halbleiterschicht enthält, und
die Sperrschicht
i) das gleiche Material wie die dritte Halbleiterschicht enthält und mehr Verunreinigungen des gleichen Leitfähigkeitstyps wie die dritte Halbleiterschicht als die dritte Halbleiterschicht enthält, oder
ii) ein anderes Material als die dritte Halbleiterschicht enthält und mehr Verunreinigungen des gleichen Leitfähigkeitstyps wie die dritte Halbleiterschicht als die dritte Halbleiterschicht enthält.

12. Photoelektrisches Umwandlungselement nach dem vorstehenden Anspruch, ferner umfassend:
eine dritten Durchkontaktierung, der die dritte Halbleiterschicht durchdringt und sich bis zur Sperrschicht erstreckt.

13. Photoelektrisches Umwandlungselement nach dem vorstehenden Anspruch, ferner umfassend:
eine vierte Durchkontaktierung, die Ladungen, die über die dritte Durchkontaktierung auf die Lichteinfallsoberflächenseite übertragen werden, auf eine Seite, die der Lichteinfallsoberfläche gegenüberliegt, entlädt.

14. Photoelektrisches Umwandlungselement nach Anspruch 11, ferner umfassend:
eine transparente Elektrodenschicht, die mit einem Abschnitt der Sperrschicht in Kontakt steht und auf der Lichteinfallsoberflächenseite der dritten Halbleiterschicht angeordnet ist; und
ein Loch, das so angeordnet ist, dass es die dritte Halbleiterschicht durchdringt, wobei
die transparente Elektrodenschicht so angeordnet ist, dass sie eine Seitenwandoberfläche des Lochs und eine Oberfläche der am Boden des Lochs angeordneten Sperrschicht bedeckt.

15. Photoelektrisches Umwandlungselement nach einem der vorstehenden Ansprüche, ferner umfassend:
eine vierte Halbleiterschicht des ersten Leitfähigkeitstyps, die auf der Lichteinfallsoberflächenseite der dritten Halbleiterschicht angeordnet ist, eine höhere Verunreinigungskonzentration als die dritte Halbleiterschicht aufweist und elektrisch getrennt von der zweiten Elektrode angeordnet ist; und
eine dritte Elektrode, die aus einem transparenten Elektrodenmaterial besteht und elektrisch mit der vierten Halbleiterschicht verbunden ist.

## Revendications

1. Élément de conversion photoélectrique comprenant :
une première couche semi-conductrice (2) d'un premier type de conductivité contenant un matériau semi-conducteur composé ;
une deuxième couche semi-conductrice (2) d'un premier type de conductivité contenant un composésemi-conducteur ayant une bande interdite plus grande que la première couche semi-conductrice et empilée sur une face de la première couche semi-conductrice opposée à la surface d'incidence de la lumière ;
une troisième couche semi-conductrice (4) d'un premier type de conductivité contenant un composésemi-conducteur composé ayant une bande interdite plus grande que celle de la première couche semi-conductrice et empilée du côté de la surface d'incidence de la lumière de la première couche semi-conductrice ;
une première couche de diffusion (5) d'un second type de conductivité, disposée de manière à pénétrer dans laseconde couche semi-conductrice à partir d'un côté de la seconde couche semi-conductrice opposé à la surface d'incidence de la lumière et s'étendant dans la première couche semi-conductrice ;
une première électrode (6) en contact avec la première couche de diffusion sur le côté de la seconde couche semi-conductrice opposée à la surface d'incidence de la lumière ;
une seconde couche de diffusion (7) d'un second type de conductivité disposée dans une direction de profondeur de la troisième couche semi-conductrice à partir d'un côté de la surface d'incidence de la lumière de la troisième couche semi-conductrice ;
une deuxième électrode (8) en contact avec la seconde couche de diffusion du côté de la surface d'incidence de la lumière de la troisième couche semi-conductrice ; et
une couche isolante (9) disposée entre la deuxième électrode et la troisième couche semi-conductrice.

2. Élément de conversion photoélectrique selon la revendication 1, dans lequel
la première couche de diffusion, la seconde couche de diffusion, la première électrode et la deuxième électrode sont fournies pour chaque pixel, et
chacune de la première couche semi-conductrice, de la deuxième couche semi-conductrice et de la troisième couche semi-conductrice est disposée sur une pluralité de régions de pixels.

3. Élément de conversion photoélectrique selon la revendication 1, dans lequel
la première couche de diffusion et la première électrode sont prévues m (m est un nombre entier de 1 ou plus) pour chaque pixel, ou sont prévues pour chaque m (m est un nombre entier de 1 ou plus) pixels, et
chacune de la première couche semi-conductrice, de la deuxième couche semi-conductrice et de la troisième couche semi-conductrice est disposée sur une pluralité de régions de pixels.

4. Élément de conversion photoélectrique selon l'une quelconque des revendications précédentes, dans lequel
la seconde couche de diffusion et la deuxième électrode sont prévues n (n est un nombre entier de 1 ou plus) pour chaque pixel, ou sont prévues pour tous les n (n est un nombre entier de 1 ou plus) pixels, et
chacune de la première couche semi-conductrice, de la deuxième couche semi-conductrice et de la troisième couche semi-conductrice sont disposées en travers d'une pluralité de régions de pixels, dans lequel une pluralité de secondes couches de diffusion et une pluralité correspondante de deuxièmes électrodes sont prévues pour chaque pixel, l'élément de conversion photoélectrique comprenant en outre :
un via électriquement connecté à la pluralité de deuxièmes électrodes dans le même pixel et pénétrant la troisième couche semi-conductrice, la première couche semi-conductrice et la deuxième couche semi-conductrice ; et
une couche de câblage reliant électriquement la pluralité de deuxièmes électrodes dans le même pixel au via correspondant.

5. Élément de conversion photoélectrique selon la revendication 4, comprenant en outre :
un via prévu pour une pluralité de pixels, connecté électriquement à la pluralité de deuxièmes électrodes dans la pluralité de pixels, et pénétrant la troisième couche semi-conductrice, la première couche semi-conductrice et la deuxième couche semi-conductrice, dans lequel
toutes les deuxièmes électrodes de la pluralité de pixels sont connectées électriquement au via.

6. Élément de conversion photoélectrique selon l'une quelconque des revendications 1 à 4, comprenant en outre :
un premier circuit de lecture disposé sur le côté de la seconde couche semi-conductrice opposée à la surface d'incidence de la lumière et connecté électriquement à la première électrode ;
un via électriquement connecté à la deuxième électrode et pénétrant dans la troisième couche semi-conductrice, la première couche semi-conductrice et la deuxième couche semi-conductrice ; et
un second circuit de lecture disposé sur la face de la deuxième couche semi-conductrice opposée à la surface d'incidence de la lumière et connecté électriquement au via.

7. Élément de conversion photoélectrique selon la revendication 6, comprenant en outre :
i) un premier substrat sur lequel sont disposées la première couche semi-conductrice, la deuxième couche semi-conductrice, la troisième couche semi-conductrice, la première couche de diffusion, la seconde couche de diffusion, la première électrode et la deuxième électrode ;
un second substrat sur lequel sont disposés le premier circuit de lecture et le second circuit de lecture, et un circuit de lecture qui génère un signal de pixel sur la base des charges prélevées par le premier circuit de lecture et des charges prélevées par le second circuit de lecture ; et
une pluralité de parties de liaison qui relient le premier substrat et le second substrat et qui transmettent et reçoivent une pluralité de signaux entre le premier substrat et le second substrat, dans lequel
le via est relié à la partie de liaison correspondante,
ou
ii) un premier substrat sur lequel sont disposées la première couche semi-conductrice, la deuxième couche semi-conductrice, la troisième couche semi-conductrice, la première couche de diffusion, la seconde couche de diffusion, la première électrode et la deuxième électrode ; et
un second substrat sur lequel sont disposés le premier circuit de lecture et le second circuit de lecture, et qui génère un signal de pixel sur la base des charges prélevées par le premier circuit de lecture et des charges prélevées par le second circuit de lecture, dans lequel
le via s'étend à travers le premier substrat jusqu'au second circuit de lecture dans le second substrat.

8. Élément de conversion photoélectrique selon l'une quelconque des revendications 6 à 7, dans lequel le via comporte :
un premier via qui transfère les premières charges générées par conversion photoélectrique vers le second circuit de lecture ; et
un deuxième via qui décharge les secondes charges générées par conversion photoélectrique, dans lequel
le premier via et le deuxième via sont prévus pour chaque pluralité de pixels,
le premier via décharge les premières charges de la pluralité correspondante de pixels, et
le deuxième via décharge les secondes charges de la pluralité correspondante de pixels.

9. Élément de conversion photoélectrique selon l'une quelconque des revendications précédentes, dans lequel
la seconde couche de diffusion est conçue pour pénétrer dans la troisième couche semi-conductrice à partir d'un côté de la surface d'incidence de la lumière de la troisième couche semi-conductrice et s'étendre dans la première couche semi-conductrice.

10. Élément de conversion photoélectrique selon l'une des revendications 1 à 8, dans lequel la seconde couche de diffusion est disposée de manière à rester à l'intérieur de la troisième couche semi-conductrice sans pénétrer dans la troisième couche semi-conductrice à partir de la surface d'incidence de la lumière de la troisième couche semi-conductrice.

11. Élément de conversion photoélectrique selon la revendication précédente, comprenant en outre :
une couche barrière disposée entre la première couche semi-conductrice et la troisième couche semi-conductrice pour bloquer les charges générées par la conversion photoélectrique dans la troisième couche semi-conductrice, dans lequel
la couche barrière contient un matériau dont la bande interdite est plus grande que celle de la troisième couche semi-conductrice, et
la couche barrière contient
i) le même matériau que la troisième couche semi-conductrice et contient plus d'impuretés du même type de conductivité que la troisième couche semi-conductrice que cette dernière, ou
ii) un matériau différent de la troisième couche semi-conductrice et contenant plus d'impuretés du même type de conductivité que la troisième couche semi-conductrice que la troisième couche semi-conductrice.

12. Élément de conversion photoélectrique selon la revendication précédente, comprenant en outre :
un troisième via pénétrant la troisième couche semi-conductrice et s'étendant jusqu'à la couche barrière.

13. Élément de conversion photoélectrique selon la revendication précédente, comprenant en outre :
un quatrième via qui décharge les charges transférées vers le côté de la surface d'incidence de la lumière à travers le troisième via vers un côté opposé à la surface d'incidence de la lumière.

14. Élément de conversion photoélectrique selon la revendication 11, comprenant en outre :
une couche d'électrode transparente en contact avec une partie de la couche barrière et disposée du côté de la surface d'incidence de la lumière de la troisième couche semi-conductrice ; et
un trou conçu pour pénétrer la troisième couche semi-conductrice, dans lequel
la couche d'électrode transparente est disposée de manière à couvrir une surface de la paroi latérale du trou et une surface de la couche barrière disposée au fond du trou.

15. Élément de conversion photoélectrique selon l'une quelconque des revendications précédentes, comprenant en outre :
une quatrième couche semi-conductrice du premier type de conductivité, disposée du côté de la surface d'incidence de la lumière de la troisième couche semi-conductrice, ayant une concentration d'impuretés plus élevée que la troisième couche semi-conductrice, et disposée de manière à être séparée électriquement de la deuxième électrode ; et
une troisième électrode constituée d'un matériau d'électrode transparent et connectée électriquement à la quatrième couche semi-conductrice.
